(19) Europäisches Patentamt / European Patent Office / Office européen des brevets

(11) **EP 3 764 546 B1**

(12) **FASCICULE DE BREVET EUROPEEN**

(45) Date de publication et mention
de la délivrance du brevet:
**30.06.2021  Bulletin 2021/26**

(51) Int Cl.:
**H03L 7/18** *(2006.01)*     **H03L 7/087** *(2006.01)*

(21) Numéro de dépôt: **20181049.6**

(22) Date de dépôt: **19.06.2020**

(54) **DISPOSITIF DE SYNTHÈSE DE FRÉQUENCE À BOUCLE DE RÉTROACTION**

VORRICHTUNG ZUR FREQUENZSYNTHESE MIT RÜCKKOPPLUNGSSCHLEIFE

FREQUENCY SYNTHESIS DEVICE WITH FEEDBACK LOOP

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **08.07.2019  FR 1907587**

(43) Date de publication de la demande:
**13.01.2021  Bulletin 2021/02**

(73) Titulaire: **COMMISSARIAT À L'ÉNERGIE
ATOMIQUE ET AUX
ÉNERGIES ALTERNATIVES
75015 Paris (FR)**

(72) Inventeur: **LACHARTRE, David
38330 Montbonnot (FR)**

(74) Mandataire: **Bonnet, Michel
Cabinet Bonnet
93, rue Réaumur
75002 Paris (FR)**

(56) Documents cités:
**WO-A1-2004/001974     US-A- 5 351 014
US-A- 6 046 643     US-A1- 2009 085 674**

Remarques:
Le dossier contient des informations techniques
présentées postérieurement au dépôt de la demande
et ne figurant pas dans le présent fascicule.

**Description**

La présente invention concerne un dispositif de synthèse de fréquence à boucle de rétroaction.

On connaît de tels dispositifs, par exemple des boucles à phase asservie dites PLL (de l'Anglais « Phase Locked Loop »), généralement appelée boucles à verrouillage de phase.

Un dispositif de ce type comporte :

- une entrée destinée à recevoir un signal électrique oscillant à une fréquence de référence ;

- une sortie destinée à fournir un signal électrique oscillant à une fréquence de sortie ;

- un circuit d'asservissement de la fréquence de sortie à la fréquence de référence, reliant l'entrée à la sortie du dispositif et comportant un bloc de comparaison de phases, un filtre de boucle et un oscillateur à fréquence contrôlée fournissant le signal électrique oscillant à la fréquence de sortie, et

- une boucle de rétroaction reliant la sortie au bloc de comparaison de phases.

L'oscillateur à fréquence contrôlée, par exemple de type VCO (de l'anglais « Voltage Controlled Oscillator »), DCO (de l'anglais « Digitally Controlled Oscillator ») ou autre, est commandé par une valeur numérique, une tension ou un courant analogique, voire une combinaison d'une valeur analogique et d'une valeur numérique. Bien que ce ne soit en général pas le cas, la fonction de transfert d'un tel oscillateur est souvent considérée comme linéaire et simplement représentée par un facteur de conversion K.

Le bloc de comparaison de phases fonctionne en général sur des fronts de signaux à comparer, c'est-à-dire lorsque ces signaux atteignent une même valeur à même pente. La comparaison de phases fournit alors elle-même un ou plusieurs signaux qui représentent la différence de phase entre les fronts des signaux comparés. La plupart du temps, les signaux résultants de la comparaison sont transformés en un seul signal d'impulsion de courant ou de tension par une pompe de charge (de l'anglais « charge pump »). Ce courant (ou tension) est d'amplitude I (ou U) constante, il prend le signe de la différence de phase et son impulsion possède une largeur proportionnelle à la différence de phase. Le bloc de comparaison de phases peut être réalisé de façon plus ou moins analogique ou numérique.

L'impulsion fournie par la pompe de charge est ensuite filtrée par le filtre de boucle qui a pour base la réponse impulsionnelle d'un filtre intégrateur. Le filtre de boucle peut lui aussi être réalisé de façon plus ou moins analogique ou numérique.

Le résultat issu du filtre de boucle est alors appliqué comme commande de l'oscillateur à fréquence contrôlée. Comme le filtre de boucle est intégrateur et que l'intégrale de la phase d'un signal périodique donne sa fréquence, la commande de l'oscillateur est bien proportionnelle à une fréquence qui va tendre vers la fréquence désirée en sortie au fur et à mesure que la différence de phase avec le signal de référence va tendre vers 0 ou vers une autre valeur constante.

Les PLL sont ainsi généralement utilisées dans les circuits électroniques en tant que sources de fréquences élevées. En effet, ces dispositifs permettent à partir d'une source à basse fréquence et de haute pureté spectrale (par exemple du quartz émettant des signaux périodiques à quelques MHz) d'obtenir des signaux périodiques à haute fréquence (par exemple quelques GHz) et avec une pureté spectrale de meilleure qualité que les dispositifs générant directement des signaux à haute fréquence.

Concrètement, pour une source de fréquence de référence basse et de haute pureté spectrale $F_{ref}$, on obtient en sortie un signal de bonne pureté spectrale à haute fréquence $F_c = \alpha . F_{ref}$, a étant un facteur multiplicatif choisi supérieur à 1. Ce facteur multiplicatif $\alpha$ est généralement variable et de valeur réelle non entière afin de faire varier les différents canaux des normes utilisées suivant l'application.

Un paramètre important des dispositifs de synthèse de fréquence est le temps $\Delta t$ d'établissement de leur régime de fonctionnement, c'est-à-dire le temps qu'ils mettent à être fonctionnels, soit au démarrage, soit lors d'un changement de canal (i.e. changement du facteur a). Ce temps $\Delta t$ perdure pendant un régime transitoire, généralement qualifié de phase d'accrochage, précédant le régime de fonctionnement. Ainsi par exemple, lors du passage $\Delta F_c$ d'une fréquence $F_c$ à une fréquence $F'_c$, le régime transitoire de fréquence synthétisée suit une enveloppe exponentielle tendant asymptotiquement vers $F'_c$ à une fréquence de résonance propre $\omega$ pendant la durée $\Delta t$. La durée $\Delta t$ de la phase d'accrochage dépend des paramètres constitutifs d'un dispositif de synthèse de fréquence et limite sa réactivité.

Un autre paramètre important des dispositifs de synthèse de fréquence est la résolution des variations possibles du facteur multiplicatif $\alpha$ et donc la finesse de réglage possible de la fréquence de sortie $F_c$ en fonction des applications ou normes visées.

D'autres paramètres à considérer, pour optimiser les dispositifs de synthèse de fréquence et la qualité des signaux périodiques de fréquence $F_c$ obtenus en sortie, incluent le bruit de phase, la gigue (de l'anglais « jitter »), les signaux parasites (de l'anglais « spurious signals ») et la consommation électrique.

Selon une conception bien connue des PLL, dite à division entière, le facteur multiplicatif $\alpha$ est choisi comme le quotient de deux valeurs entières N et D où la valeur N est généralement supérieure à D. Pour parvenir à cet asservissement $F_c = \alpha.F_{ref} = N/D.F_{ref}$, un diviseur de fréquence de facteur D est disposé dans le circuit d'asservissement entre l'entrée et une première entrée de comparaison d'un comparateur du bloc de comparaison de phases, tandis qu'un diviseur de fréquence de facteur N est disposé dans la boucle de rétroaction entre la sortie, qui correspond à la sortie de l'oscillateur à fréquence contrôlée, et une deuxième entrée de comparaison du comparateur de phases. De la sorte, la fréquence des deux signaux comparés par le comparateur de phases est destinée à converger vers $F_{ref}/D = F_c/N$ lorsque la boucle est verrouillée. Ainsi, en sortie du comparateur de phases, bien que filtrée par le filtre de boucle, cette fréquence $F_{ref}/D$ se retrouve au niveau de la commande de l'oscillateur à fréquence contrôlée et donc en tant que parasite dans le spectre du signal de sortie. Par ailleurs, il est clair que la valeur de D est directement corrélée à la résolution des variations possibles du facteur multiplicatif $\alpha$ puisque ces variations se font, pour différentes valeurs de N possibles, par pas fréquentiels de $F_{ref}/D$.

Il en résulte que pour augmenter la résolution des variations possibles du facteur multiplicatif a, il conviendrait d'augmenter la valeur de D. Mais dans ce cas, la fréquence $F_{ref}/D$ serait réduite et il conviendrait alors de réduire également la bande passante du filtre de boucle pour limiter les parasites résultants dans le spectre du signal de sortie. Or limiter la bande passante du filtre de boucle conduit à allonger le temps $\Delta t$ d'établissement du régime de fonctionnement. Par conséquent, optimiser conjointement les deux paramètres importants d'une PLL, que constituent le temps d'établissement du régime de fonctionnement et la résolution des variations possibles du facteur multiplicatif a, est impossible à réaliser avec une PLL à division entière.

Par ailleurs, les contributions au bruit de phase induit en sortie dépendent directement elles aussi de la fréquence de coupure de la PLL. Dans la bande passante, le bruit est dominé par la contribution du signal de référence. Bien que multiplié par a, il reste en général moindre que celui apporté par la PLL elle-même. Il peut ainsi être préférable de monter la fréquence de coupure de la PLL afin d'abaisser le bruit de phase dans la partie basse du spectre obtenu en sortie. Mais dans ce cas, c'est au détriment de la valeur de D. Par conséquent, optimiser conjointement le bruit de phase et la résolution des variations possibles du facteur multiplicatif a, est impossible à réaliser avec une PLL à division entière.

Une solution partielle à ces inconvénients consiste à concevoir une PLL à pas fractionnaires comme enseigné dans la demande de brevet FR 2 763 196 A1. Dans ce cas, le diviseur de fréquence disposé dans la boucle de rétroaction commute entre le facteur N et le facteur N+1 selon une proportion souhaitée prédéterminée, de manière à produire en moyenne, grâce au filtre de boucle, un facteur multiplicatif $\alpha = (N+\beta)/D$, avec $0 \le \beta \le 1$. Ainsi, sans augmenter la valeur de D, il devient possible d'augmenter la résolution des variations possibles du facteur multiplicatif a.

Cependant, pour réaliser cette commutation du diviseur de la boucle de rétroaction entre les deux valeurs N et N+1 selon une proportion souhaitée, un modulateur Delta-Sigma est généralement utilisé. Ce modulateur a la particularité de générer un signal résultant d'une quantification du coefficient $\beta$ sur 1 bit et la quantification produit nécessairement une erreur de quantification qui, dans le cas du modulateur Delta-Sigma, n'est pas répartie uniformément dans le spectre de sortie mais est amplifiée dans les hautes fréquences. Le filtre de boucle atténue donc partiellement le bruit résultant de cette erreur. Néanmoins, une PLL à pas fractionnaires produit un signal qui reste plus ou moins entaché d'un bruit supplémentaire dû à la génération du coefficient $\beta$. D'ailleurs plus $\beta$ aura besoin de précision (i.e. pour une meilleure résolution à N et D constants), plus ce bruit supplémentaire sera important.

De plus, une PLL à pas fractionnaire n'optimise pas non plus le bruit de phase indépendamment du facteur multiplicatif a, la fréquence de fonctionnement du comparateur de phases restant dépendante de ce facteur.

Une autre solution consiste à ne pas utiliser de diviseurs de fréquences mais des accumulateurs de phases, comme enseigné par exemple dans les demandes de brevets US 2011/0133795 A1 et WO 2009/053531 A1, ou dans l'article de Staszewski et al, intitulé « Phase-domain all-digital phase-locked loop », publié en mars 2005 dans IEEE Transactions on Circuits and Systems-II: express briefs, vol. 52, n° 3, pages 159-163, de manière à calculer numériquement des accumulations de phases à partir de chacun des signaux de référence et de sortie plutôt que de réaliser une comparaison de phases sur des signaux issus de diviseurs. Cette autre solution est en particulier bien adaptée à la conception de PLL dites « entièrement numériques ». Une autre solution consiste à utiliser un diviseur de fréquence en combinaison avec des accumulateurs de phases, comme enseigne par exemple dans la demande de brevet US 2009/085674 A1.

Conformément à cette autre solution, l'invention concerne plus précisément un dispositif de synthèse de fréquence à boucle de rétroaction comportant :

- une entrée destinée à recevoir un signal électrique oscillant à une fréquence de référence ;
- une sortie destinée à fournir un signal électrique oscillant à une fréquence de sortie ;
- un circuit d'asservissement de la fréquence de sortie à la fréquence de référence, reliant l'entrée à la sortie du dispositif et comportant un premier accumulateur de phase cadencé à une fréquence liée à la fréquence de référence, un bloc de comparaison de phases, un filtre de boucle et un oscillateur à fréquence contrôlée fournissant le signal électrique oscillant à la fréquence de sortie ; et

- une boucle de rétroaction reliant la sortie au bloc de comparaison de phases, comportant un deuxième accumulateur de phase cadencé à une fréquence liée à la fréquence de sortie, les premier et deuxième accumulateurs de phase étant aptes à fournir un même nombre T de valeurs discrètes d'accumulation de phase possibles.

Ainsi, pour une PLL à division entière de facteur multiplicatif $\alpha$ = N/D, le premier accumulateur de phase peut par exemple être associé à une valeur d'incrément de phase égale à N et le deuxième à une valeur d'incrément de phase égale à D.

Il résulte de cette autre solution que la fréquence de fonctionnement du comparateur de phases peut être rendue indépendante du facteur $\alpha$ et donc du choix de D. D peut alors être augmenté dans des proportions bien plus importantes que celles des dispositifs à diviseurs de fréquences, tout en conservant une fréquence de fonctionnement élevée du comparateur de phases, d'où une meilleure résolution sans concession sur le temps $\Delta t$ d'établissement du régime de fonctionnement ou sur le bruit de phase.

Cependant cette autre solution fournit des valeurs numériques en sorties des accumulateurs de phases et celles-ci sont cadencées selon des fréquences différentes. Plus précisément, dans les documents US 2011/0133795 A1, WO 2009/053531 A1 et dans l'article de Staszewski et al précité, la fréquence sur laquelle sont cadencées les valeurs numériques issues du premier accumulateur de phase est $F_{ref}$, tandis que la fréquence sur laquelle sont cadencées les valeurs numériques issues du deuxième accumulateur de phase est $F_c$. Les données fournies au comparateur de phases, qui n'est rien d'autre qu'un soustracteur numérique, ne sont donc pas synchronisées entre elles, ce qui pose un problème.

Ce problème est par exemple résolu de façon partielle et non satisfaisante dans WO 2009/053531 A1, ou dans l'article de Staszewski et al précité, en compliquant singulièrement la boucle de rétroaction pour tenter de resynchroniser entre elles les données numériques issues des deux accumulateurs de phases. Cette resynchronisation engendre par ailleurs un bruit supplémentaire.

Ce problème est en revanche résolu de façon plus satisfaisante dans le document de brevet US 9,509,320 B2 qui propose de disposer des convertisseurs numérique/analogique en sorties des accumulateurs de phases et de fournir les signaux résultants à un comparateur de phases analogique implémenté en pratique par un soustracteur de ces signaux.

Néanmoins, les accumulateurs de phases ne peuvent pas produire des valeurs s'incrémentant indéfiniment. Il est généralement nécessaire de prévoir une valeur seuil de phase accumulée au-delà de laquelle il est prévu de soustraire une valeur de modulo. Mais il est alors également nécessaire de prévoir un mécanisme de synchronisation des soustractions de la valeur de modulo entre les accumulateurs de phases, ce qui présente une certaine complexité et est susceptible d'engendrer un bruit parasite transitoire perceptible en sortie de l'oscillateur.

Il peut ainsi être souhaité de prévoir un dispositif de synthèse de fréquence à boucle de rétroaction qui permette de s'affranchir d'au moins une partie des problèmes et contraintes précités.

Il est donc proposé un dispositif de synthèse de fréquence à boucle de rétroaction comportant :

- une entrée destinée à recevoir un signal électrique oscillant à une fréquence de référence ;

- une sortie destinée à fournir un signal électrique oscillant à une fréquence de sortie ;

- un circuit d'asservissement de la fréquence de sortie à la fréquence de référence, reliant l'entrée à la sortie du dispositif et comportant un premier accumulateur de phase cadencé à une fréquence liée à la fréquence de référence, un bloc de comparaison de phases, un filtre de boucle et un oscillateur à fréquence contrôlée fournissant le signal électrique oscillant à la fréquence de sortie ; et

- une boucle de rétroaction reliant la sortie au bloc de comparaison de phases, comportant un deuxième accumulateur de phase cadencé à une fréquence liée à la fréquence de sortie, les premier et deuxième accumulateurs de phase étant aptes à fournir un même nombre T de valeurs discrètes d'accumulation de phase possibles ;

dans lequel :

- le circuit d'asservissement est configuré pour fournir, au bloc de comparaison de phases, T premiers signaux logiques distincts dont les niveaux logiques dépendent continûment des valeurs d'accumulation de phase fournies par le premier accumulateur de phase selon une première matrice de correspondance multi-phases entre les T valeurs discrètes d'accumulation de phase possibles et les T premiers signaux ;

- la boucle de rétroaction est configurée pour fournir, au bloc de comparaison de phases, T deuxièmes signaux logiques distincts dont les niveaux logiques dépendent continûment des valeurs d'accumulation de phase fournies par le deuxième accumulateur de phase selon une deuxième matrice de correspondance multi-phases entre les T valeurs discrètes d'accumulation de phase possibles et les T deuxièmes signaux ; et

- le bloc de comparaison de phases comporte T comparateurs de phases à portes logiques recevant respectivement en temps continu les T premiers signaux logiques sur T premières entrées de comparaison et les T deuxièmes signaux logiques sur T deuxièmes entrées de comparaison.

Ainsi, il n'est plus nécessaire de gérer la soustraction d'une valeur de modulo puisque cela peut se faire implicitement et automatiquement par la prise en compte des T valeurs discrètes d'accumulation de phase possibles dans chaque matrice de correspondance multi-phases avec les T premiers ou T deuxièmes signaux logiques. En effet, chaque saut de phase correspond à un saut équivalent dans les lignes ou colonnes de la matrice, avec retour en début de lignes ou colonnes dès que la valeur maximale ou modulo T est atteinte, et le nombre de signaux logiques est égal à cette valeur de modulo. Il n'est donc *a fortiori* plus nécessaire de gérer de synchronisation de soustraction de valeur de modulo entre signaux à comparer.

Par ailleurs, le fait de produire 2T signaux logiques dépendant continument des valeurs d'accumulation de phase fournies par les accumulateurs de phase et de les comparer entre eux à l'aide de portes logiques permet de se passer d'une conversion numérique/analogique spécifique. De plus, on constate en pratique que la résolution en fréquence ne dépend pas du nombre T de comparateurs de phases dans le bloc de comparaison.

Il en résulte des performances de haute résolution au moins aussi satisfaisantes que dans le document de brevet US 9,509,320 B2 avec une plus grande simplicité d'implémentation par suppression de toute contrainte de synchronisation.

De façon optionnelle :

- le circuit d'asservissement comporte un premier convertisseur multi-phases entre le premier accumulateur de phase et le bloc de comparaison de phases, configuré pour implémenter la première matrice de correspondance multi-phases ; et

- la boucle de rétroaction comporte un deuxième convertisseur multi-phases entre le deuxième accumulateur de phase et le bloc de comparaison de phases, configuré pour implémenter la deuxième matrice de correspondance multi-phases.

De façon optionnelle également, chacun des premier et deuxième convertisseurs multi-phases implémente sa matrice de correspondance multi-phases sous la forme d'un ensemble de portes logiques recevant en entrée une valeur courante d'accumulation de phase codée en binaire sur $\ln(T)/\ln(2)$ bits, où $\ln(.)$ est la fonction logarithme népérien, et fournissant en sortie T valeurs courantes de niveaux logiques.

De façon optionnelle également, chaque coefficient de chacune des première et deuxième matrices de correspondance multi-phases est soit à une première valeur binaire indicatrice d'un premier niveau logique de signal logique, soit à une deuxième valeur binaire indicatrice d'un deuxième niveau logique de signal logique.

De façon optionnelle également, chaque ligne ou colonne de chacune des première et deuxième matrices de correspondance multi-phases, lorsque cette ligne ou colonne indique les niveaux logiques que doit prendre l'un des T premiers ou deuxièmes signaux logiques pour les T valeurs discrètes d'accumulation de phase possibles, ne présente circulairement par modulo T qu'une seule transition de la première valeur binaire vers la deuxième valeur binaire pour une première moitié des T valeurs discrètes d'accumulation de phase possibles et qu'une seule transition de la deuxième valeur binaire vers la première valeur binaire pour une deuxième moitié des T valeurs discrètes d'accumulation de phase possibles.

De façon optionnelle également, chaque ligne ou colonne de chacune des première et deuxième matrices de correspondance multi-phases, lorsque cette ligne ou colonne indique les niveaux logiques que doit prendre l'un des T premiers ou deuxièmes signaux logiques pour les T valeurs discrètes d'accumulation de phase possibles, ne diffère de celle qui la précède ou de celle qui la suit que par un décalage d'une colonne ou respectivement d'une ligne modulo T des valeurs de coefficients qu'elle contient, ce décalage restant dans le même sens de la première à la dernière ligne ou colonne.

De façon optionnelle également, chacune des première et deuxième matrices de correspondance est symétrique.

De façon optionnelle également, les première et deuxième matrices de correspondance sont identiques.

De façon optionnelle également, le bloc de comparaison de phases comporte T pompes de charge recevant respectivement en temps continu T paires de signaux impulsionnels fournies par les T comparateurs de phases et fournissant respectivement en temps continu T courants de sortie.

De façon optionnelle également, le bloc de comparaison de phases comporte un sommateur de courants recevant en parallèle les T courants de sortie fournis par les T pompes de charge pour fournir un unique courant sommé en sortie du bloc de comparaison de phases.

L'invention sera mieux comprise à l'aide de la description qui va suivre, donnée uniquement à titre d'exemple et faite en se référant aux dessins annexés dans lesquels :

[Fig.1] la figure 1 représente schématiquement la structure générale d'un dispositif de synthèse de fréquence à boucle de rétroaction, selon un premier mode de réalisation de l'invention,

[Fig.2] la figure 2 est un chronogramme illustrant les évolutions de valeurs d'accumulation de phase obtenues à l'aide du dispositif de la figure 1,

[Fig.3] la figure 3 est un chronogramme illustrant les évolutions de T premiers ou deuxièmes signaux logiques fournis par le dispositif de la figure 1, en dépendance de valeurs d'accumulation de phase obtenues par sauts unitaires,

[Fig.4] la figure 4 est un chronogramme illustrant les évolutions de T premiers ou deuxièmes signaux logiques fournis par le dispositif de la figure 1, en dépendance de valeurs d'accumulation de phase obtenues par sauts de trois unités,

[Fig.5] la figure 5 est un spectre à échelle logarithmique de fréquences illustrant les caractéristiques d'un signal obtenu à l'aide du dispositif de la figure 1,

[Fig.6] la figure 6 est un spectre à échelle logarithmique de fréquences illustrant les caractéristiques d'un autre signal obtenu à l'aide du dispositif de la figure 1,

[Fig.7] la figure 7 est un diagramme indiquant une évolution de résolution en fréquence du dispositif de la figure 1 en fonction d'un nombre n de bits codant T valeurs d'accumulation de phases possibles,

[Fig.8] la figure 8 représente schématiquement la structure générale d'un dispositif de synthèse de fréquence à boucle de rétroaction, selon un deuxième mode de réalisation de l'invention,

[Fig.9] la figure 9 représente schématiquement la structure générale d'un dispositif de synthèse de fréquence à boucle de rétroaction, selon un troisième mode de réalisation de l'invention,

[Fig.10] la figure 10 est un spectre à échelle logarithmique de fréquences illustrant les caractéristiques d'un signal obtenu à l'aide du dispositif de la figure 9,

[Fig.11] la figure 11 est un ensemble de trois chronogrammes illustrant les évolutions de différentes grandeurs du dispositif de la figure 1 en régime transitoire de démarrage,

[Fig.12] la figure 12 est un ensemble de trois chronogrammes illustrant les évolutions de différentes grandeurs du dispositif de la figure 1 en régime établi de fonctionnement,

[Fig.13] la figure 13 représente un exemple de filtre de boucle pour l'un ou l'autre des dispositifs des figures 1 et 8,

[Fig.14] la figure 14 représente un autre exemple de filtre de boucle pour l'un quelconque des dispositifs des figures 1, 8 et 9,

[Fig.15] la figure 15 représente schématiquement l'architecture d'un exemple de comparateur de phases pour l'un quelconque des dispositifs de synthèse de fréquence des figures 1, 8 et 9,

[Fig.16] la figure 16 est un ensemble de quatre chronogrammes illustrant les évolutions des signaux logiques en entrée et en sortie du comparateur de phase de la figure 15,

[Fig.17] la figure 17 représente schématiquement l'architecture d'un exemple de pompe de charge pour l'un quelconque des dispositifs de synthèse de fréquence des figures 1, 8 et 9,

[Fig.18] la figure 18 représente schématiquement l'architecture d'un exemple d'accumulateur de phase adapté pour le dispositif de synthèse de fréquence de la figure 1 ou 8,

[Fig.19] la figure 19 représente schématiquement l'architecture d'un exemple d'accumulateur de phase à réduction de dynamique par modulation Delta-Sigma adapté pour le dispositif de synthèse de fréquence de la figure 9, et

[Fig.20] la figure 20 représente schématiquement l'architecture d'un exemple de convertisseur multi-phases pour l'un quelconque des dispositifs de synthèse de fréquence des figures 1, 8 et 9.

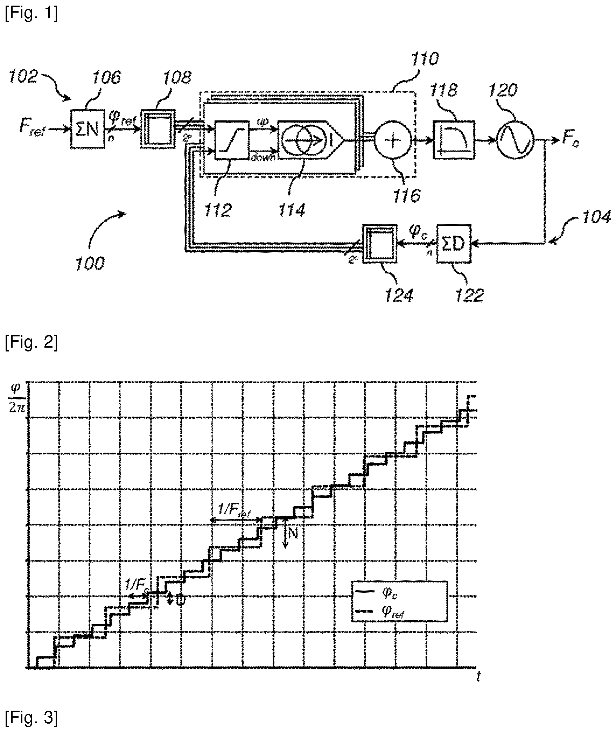

La figure 1 représente schématiquement un dispositif 100 de synthèse de fréquence de type PLL, selon un premier mode de réalisation de l'invention. Ce dispositif 100 présente une entrée destinée à recevoir un signal périodique oscillant à une fréquence de référence $F_{ref}$ et une sortie destinée à fournir un signal périodique oscillant à une fréquence de sortie $F_c$.

Il comporte en outre un circuit 102 d'asservissement de la fréquence de sortie $F_c$ à la fréquence de référence $F_{ref}$ et une boucle de rétroaction 104 pour la fourniture d'informations issues du signal périodique de sortie au circuit d'asservissement 102.

Plus précisément, le circuit d'asservissement 102 relie l'entrée à la sortie du dispositif 100 et comporte :

- un premier accumulateur de phase 106 cadencé à une fréquence liée à la fréquence de référence $F_{ref}$ : dans l'exemple de la figure 1, la cadence est directement celle de la fréquence $F_{ref}$ et l'accumulateur de phase 106 présente une valeur entière d'incrément de phase notée N dans un ensemble ordonné de T valeurs discrètes d'accumulation de phase possibles ;

- un premier convertisseur multi-phases 108 disposé en sortie du premier accumulateur de phase 106, recevant une valeur codée de phase accumulée $\varphi_{ref}$ fournie par le premier accumulateur de phase 106 et fournissant T premiers signaux logiques dont les niveaux logiques dépendent en temps continu de cette valeur de phase $\varphi_{ref}$ selon une première matrice de correspondance multi-phases entre les T valeurs discrètes d'accumulation de phase possibles et les T premiers signaux : selon une implémentation simple et préférée, T est une puissance de 2, $T = 2^n$, et la valeur de phase accumulée $\varphi_{ref}$ fournie par le premier accumulateur de phase 106 est codée de 1 à T sur n bits comme illustré sur la figure 1 ;

- un bloc de comparaison de phases 110 comportant : T comparateurs de phases 112 à portes logiques recevant respectivement en temps continu les T premiers signaux logiques sur T premières entrées de comparaison et fournissant respectivement en temps continu T paires de signaux « up » et « down » ; T pompes de charge 114 recevant respectivement en temps continu les T paires de signaux « up » et « down » fournies par les T comparateurs de phases 112 et fournissant respectivement en temps continu T courants de sortie ; et un sommateur de courants 116 recevant en parallèle les T courants de sortie fournis par les T pompes de charge 114 pour fournir un unique courant sommé en sortie du bloc de comparaison de phases 110 ;

- un filtre de boucle 118 disposé en sortie du bloc de comparaison de phases 110 pour recevoir le courant sommé : dans l'exemple de la figure 1, il s'agit d'un filtre analogique ; et

- un oscillateur à fréquence contrôlée 120 disposé en sortie du filtre de boucle 118 et fournissant le signal périodique oscillant à la fréquence de sortie : dans l'exemple de la figure 1, l'oscillateur 120 est de type VCO, c'est-à-dire commandé en tension analogique fournie par le filtre de boucle 118.

Plus précisément également, la boucle de rétroaction 104 récupère le signal périodique fourni par l'oscillateur 120 pour le fournir en entrée d'un deuxième accumulateur de phase 122 cadencé à une fréquence liée à la fréquence de sortie $F_c$ : dans l'exemple de la figure 1, la cadence est directement celle de la fréquence $F_c$ et l'accumulateur de phase 122 présente une valeur entière d'incrément de phase notée D dans l'ensemble ordonné précité de T valeurs discrètes d'accumulation de phase possibles. La boucle de rétroaction 104 comporte en outre un deuxième convertisseur multi-phases 124 disposé en sortie du deuxième accumulateur de phase 122, recevant une valeur codée de phase accumulée $\varphi_c$ fournie par le deuxième accumulateur de phase 122 et fournissant T deuxièmes signaux logiques dont les niveaux logiques dépendent en temps continu de cette valeur de phase $\varphi_c$ selon une deuxième matrice de correspondance multi-phases entre les T valeurs discrètes d'accumulation de phase possibles et les T deuxièmes signaux : selon l'implémentation simple et préférée mentionnée précédemment, la valeur de phase accumulée $\varphi_c$ fournie par le deuxième accumulateur de phase 122 est codée de 1 à T sur n bits comme illustré sur la figure 1.

Les T deuxièmes signaux logiques fournis en sortie du deuxième convertisseur multi-phases 124 sont respectivement reçus sur T deuxièmes entrées de comparaison des comparateurs de phases 112.

Dans l'exemple non limitatif de la figure 1, les convertisseurs multi-phases 108 et 124 sont présentés comme des dispositifs différents des accumulateurs de phases 106 et 122. Mais ils pourraient en variante être intégrés dans les accumulateurs, lesquels fourniraient alors directement les T premiers et deuxièmes signaux logiques au bloc de comparaison de phases 110.

En pratique, on notera aussi que le sommateur de courants 116 peut être implémenté sous la simple forme d'un raccordement électrique des T sorties de pompes de charge 114.

Un accumulateur de phase est, d'une façon générale, un dispositif cadencé selon une fréquence d'horloge prédéterminée pour incrémenter, d'une valeur d'incrément de phase prédéterminée, une valeur numérique fournie en sortie à chaque front montant ou descendant de l'horloge.

Ainsi, comme illustré sur la figure 2 par la courbe en traits interrompus pour le premier accumulateur de phase 106 (cadencé par $F_{ref}$ et de valeur d'incrément de phase N), la valeur numérique de phase accumulée $\varphi_{ref}$ est proportionnelle à une rampe temporelle rectiligne théorique de pente $2\pi.N.F_{ref}$. En réalité, elle est échantillonnée à la fréquence $F_{ref}$ et prend des valeurs numériques successives N.i à des instants successifs $t_i$ où i est l'indice des échantillons successifs.

Ainsi également, comme illustré sur la figure 2 par la courbe en trait continu pour le deuxième accumulateur de phase 122 (cadencé par $F_c$ et de valeur d'incrément de phase D), la valeur numérique de phase accumulée $\varphi_c$ est proportionnelle à une rampe temporelle rectiligne théorique de pente $2\pi.D.F_c$. En réalité, elle est échantillonnée à la fréquence $F_c$ et prend des valeurs numériques successives D.j à des instants successifs $t_j$ où j est l'indice des échantillons successifs.

En théorie, à chaque instant t :

[Math. 1]

$$\left[\varphi_{ref} - \varphi_c\right](t) = 2\pi \cdot t \cdot \left(N \cdot F_{ref} - D \cdot F_c\right).$$

A l'aide du bloc de comparaison de phases 110, lorsque la PLL est verrouillée, on retrouve donc bien théoriquement la relation $F_c = \alpha.F_{ref} = N/D.F_{ref}$.

Mais en pratique, les instants $t_i$ et $t_j$ ne sont pas synchronisés entre eux et ne permettent pas une comparaison directe des échantillons de phases accumulées.

Il est donc avantageux et astucieux de :

- convertir continument la valeur numérique de phase accumulée $\varphi_{ref}$ en T premiers signaux logiques distincts à l'aide du premier convertisseur multi-phases 108 (ou directement dans l'accumulateur de phase 106),

- convertir continument la valeur numérique de phase accumulée $\varphi_c$ en T deuxièmes signaux logiques distincts à l'aide du deuxième convertisseur multi-phases 124 (ou directement dans l'accumulateur de phase 122), et

- comparer les 2T signaux logiques résultants deux à deux à l'aide du bloc de comparaison de phases 110 à T comparateurs logiques en temps continu et T pompes de charges dont les sorties sont sommées.

En effet, en procédant de la sorte par conversions multi-phases plutôt que par une tentative de resynchronisation des échantillons de phases accumulées, ou plutôt que par une comparaison directe de phases de signaux analogiques sans calcul préalable de ces phases, on obtient une comparaison de phase totalement indépendante des fréquences de mise à jour des valeurs d'accumulation de phases à comparer. Il devient donc envisageable de concevoir un dispositif de synthèse de fréquence de facteur multiplicatif $\alpha = N/D$ à forte valeur pour D, donc à forte résolution en fréquence, sans conséquences préjudiciables sur le temps d'établissement du régime de fonctionnement et sur les bruits de phases ou autres.

Selon le mode de réalisation détaillé précédemment, les valeurs numériques de phases accumulées $\varphi_{ref}$ et $\varphi_c$ sont respectivement incrémentées des valeurs N et D à chaque front montant ou descendant de l'horloge correspondante, c'est-à-dire aux instants $t_i$ pour la valeur numérique représentant la phase accumulée $\varphi_{ref}$ et aux instants $t_j$ pour la valeur numérique représentant la phase accumulée $\varphi_c$. Si rien d'autre n'était prévu, ces valeurs numériques seraient destinées à croître indéfiniment, ce qui poserait alors un problème de saturation des accumulateurs. Mais le codage des valeurs ($\varphi_{ref}$ et $\varphi_c$ sur sur un nombre limité n de bits et la conversion multi-phases réalisée à l'aide d'une matrice de correspondance à nombre limité T de lignes et colonnes permettent de réaliser implicitement une incrémentation circulaire à modulo T des valeurs N et D selon laquelle dès que la T-ième valeur de phase est atteinte parmi les T valeurs possibles, on revient automatiquement à la première.

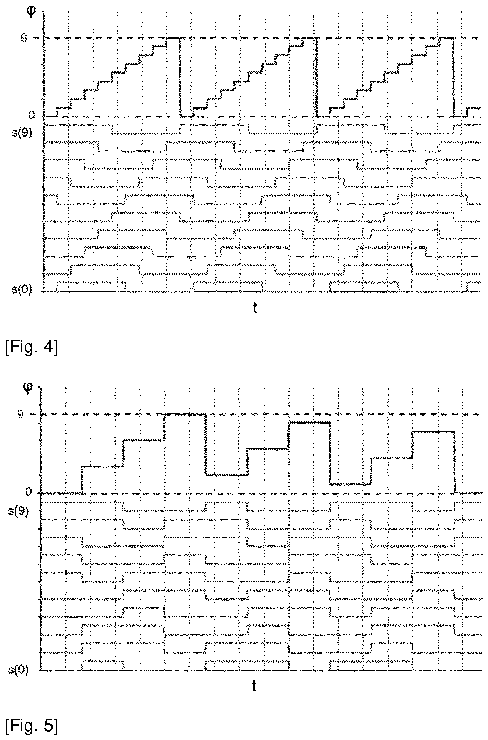

Un exemple de conversion multi-phases pour T = 10 est illustré par les figures 3 et 4 selon la matrice de correspondance suivante, par exemple commune aux premier et deuxième convertisseurs multi-phases :

[Tableau 1]

| φ | s <9:0> |
|---|---------|
| 0 | 1111100000 |
| 1 | 1111000001 |
| 2 | 1110000011 |
| 3 | 1100000111 |
| 4 | 1000001111 |
| 5 | 0000011111 |
| 6 | 0000111110 |
| 7 | 0001111100 |
| 8 | 0011111000 |
| 9 | 0111110000 |

T = 10 valeurs discrètes d'accumulation de phase sont possibles et codées de 0 à 9. Pour chacune de ces valeurs codées, la ligne correspondante de la matrice de correspondance ci-dessus indique un niveau logique pour chacun des T signaux logiques constituant le signal numérique s<9:0>, ordonnés en colonnes de s<9> à s<0>. Dans un mode de réalisation avantageux, ce niveau logique est binaire, le signal logique étant soit à un premier niveau noté « 0 », soit à un deuxième niveau noté « 1 ».

La figure 3 est ainsi un chronogramme illustrant les évolutions temporelles des T premiers ou deuxièmes signaux logiques s<0> à s<9> fournis par le premier ou deuxième convertisseur multi-phases 108 ou 124 à l'aide de la matrice de correspondance ci-dessus, en dépendance de valeurs d'accumulation de phase $\varphi = \varphi_{ref}$ ou $\varphi_c$ successivement obtenues par sauts unitaires, c'est-à-dire pour N ou D égal à 1. Plus précisément, dans ce chronogramme $\varphi$ prend successivement les valeurs 0, 1, 2, 3, 4, 5, 6, 7, 8, 9, 0, 1, 2, 3, 4, 5, 6, 7, 8, 9, 0, 1, 2, 3, 4, 5, 6, 7, 8, 9, 0, 1, ...

La figure 4 est un chronogramme illustrant les évolutions temporelles des T premiers ou deuxièmes signaux logiques s<0> à s<9> fournis par le premier ou deuxième convertisseur multi-phases 108 ou 124 à l'aide de la même matrice de correspondance ci-dessus, en dépendance de valeurs d'accumulation de phase $\varphi = \varphi_{ref}$ ou $\varphi_c$ successivement obtenues par sauts de trois unités, c'est-à-dire pour N ou D égal à 3. Plus précisément, dans ce chronogramme $\varphi$ prend successivement les valeurs 0, 3, 6, 9, 2, 5, 8, 1, 4, 7, 0, ...

D'une façon plus générale et par convention, chaque matrice de correspondance multi-phases comporte T lignes représentatives des T valeurs discrètes d'accumulation de phase possibles et T colonnes représentatives des T signaux logiques. Selon une autre convention, elle pourrait comporter T colonnes représentatives des T valeurs discrètes d'accumulation de phase possibles et T lignes représentatives des T signaux logiques. Avantageusement, elle est symétrique, de sorte que cette convention est tout à fait indifférente.

Comme le montrent les figures 3 et 4, pour que les signaux logiques résultant des conversions multi-phases soient pleinement pertinents à comparer deux à deux, il est avantageux que chaque colonne de chaque matrice de correspondance multi-phases, chaque colonne indiquant par convention les niveaux logiques que doit prendre l'un des T signaux logiques résultant pour les T valeurs discrètes d'accumulation de phase possibles, ne présente circulairement par modulo T qu'une seule transition de la première valeur logique binaire vers la deuxième valeur logique binaire pour une première moitié des T valeurs discrètes d'accumulation de phase possibles et qu'une seule transition de la deuxième valeur logique binaire vers la première valeur logique binaire pour une deuxième moitié des T valeurs discrètes d'accumulation de phase possibles. Il est également avantageux que chaque colonne ne diffère de celle qui la précède ou de celle qui la suit que par un décalage d'une ligne modulo T des valeurs de coefficients qu'elle contient, ce décalage restant dans le même sens de la première à la dernière colonne.

D'un point de vue spectral, avant la conversion multi-phases des valeurs d'accumulation de phase issues des deux accumulateurs de phases 106 et 122, les deux signaux numériques reçus par les comparateurs de phases 112 du bloc de comparaison de phases 110 ont une réponse en fréquence très proche d'une droite qui part de la fréquence nulle et qui décroit avec la fréquence.

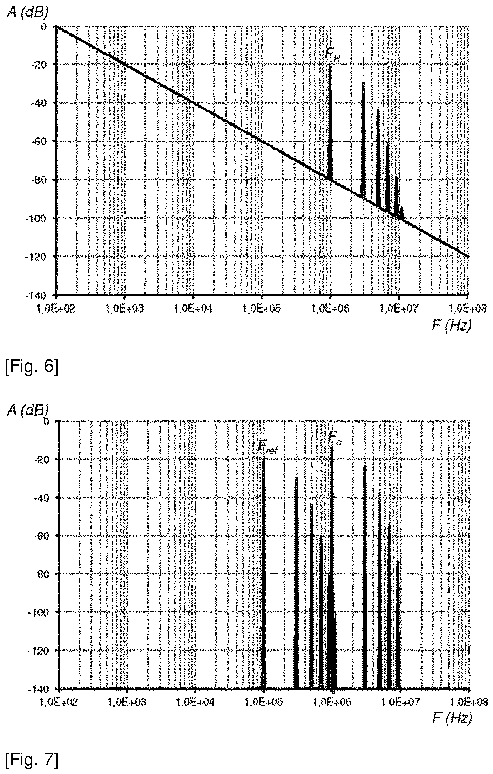

A cet égard, la figure 5 illustre, selon une échelle logarithmique des fréquences, la réponse en fréquence de l'un des signaux numériques résultant de l'accumulation d'une rampe de phase engendrée par un accumulateur de phase échantillonné par un signal d'horloge de fréquence $F_H$ égale à 1 MHz. Le spectre illustré sur cette figure est ainsi parasité par la fréquence $F_H$ et ses harmoniques, phénomène bien connu de l'homme de l'art. Cependant l'échantillonnage équivalent réalisé par l'accumulateur de phase ne génère ni repliement de spectre ni bruit de quantification car il est appliqué à l'identique à chaque front montant ou descendant d'horloge.

Par ailleurs, comme la comparaison logique réalisée par chaque comparateur de phases 112 est une opération linéaire en temps continu, le spectre du résultat de cette opération est une soustraction des spectres des deux signaux numériques résultant des valeurs d'accumulation de phases ($\varphi_{ref}$ et $\varphi_c$ sans ajout de bruit supplémentaire.

La figure 6 illustre ainsi, selon une échelle logarithmique des fréquences, le spectre résultant en sortie du sommateur de courants 116 pour les valeurs expérimentales de la figure 5. Lorsque la boucle de PLL se stabilise, les droites des réponses en fréquence tendent à se compenser (ici à -140 dB). Seuls émergent les pics parasites des fréquences fondamentales $F_{ref}$, $F_c$ et leurs harmoniques. Lorsque le facteur multiplicatif $\alpha$ est supérieur à 1, le premier pic parasite se trouve à la fréquence $F_{ref}$, alors que dans un dispositif de synthèse de fréquence classique à division entière et à diviseurs de fréquences, il se trouverait à la fréquence $F_{ref}/D$. Il s'agit là d'une amélioration importante qui permet, soit d'augmenter la fréquence de coupure du dispositif de synthèse de fréquence sous condition de stabilité en améliorant d'autant le temps $\Delta t$ d'établissement de son régime de fonctionnement, soit de beaucoup mieux atténuer les parasites et le bruit de phase sans détériorer ce temps $\Delta t$.

Il apparaît également clairement que le dispositif de synthèse de fréquence 100 tel que décrit précédemment permet d'obtenir un facteur multiplicatif $\alpha$ = N/D à forte valeur pour D et donc à forte résolution en fréquence. En effet, les accumulateurs de phases 106 et 122 peuvent aisément être implémentés avec des moyens de mémorisation de nombres codés sous forme binaire, en particulier pour des valeurs entières positives telles que N et D. Ils doivent donc juste prévoir un nombre suffisant de bits pour réaliser les opérations arithmétiques d'accumulation de N et D dans l'ensemble des T valeurs d'accumulation de phase possibles. Ce nombre n doit être supérieur ou égal au nombre de bits nécessaire pour représenter, non seulement N et D, mais également T.

En conclusion, le nombre minimal de bits nécessaires en sortie des accumulateurs 106 et 122 peut être défini par la relation suivante, un bit supplémentaire étant nécessaire à cause de la conversion multi-phases :

[Math. 2]

$$n = \text{ENT}\big[\log_2\big(\text{MAX}(N-1, D-1)\big)\big] + 2,$$

où ENT[] est la fonction Partie Entière, ENT[] + 1 représentant alors la fonction d'arrondi entier supérieur, et où MAX() est la fonction qui retourne le maximum entre deux valeurs.

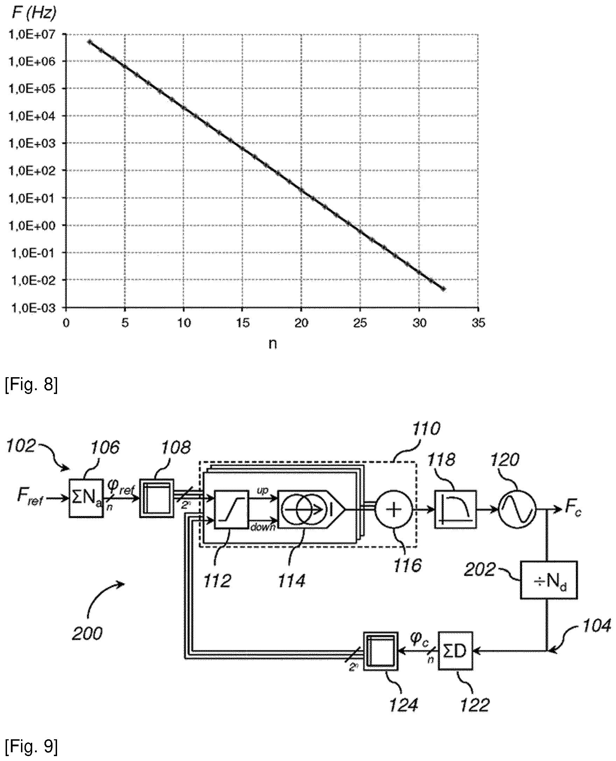

Conformément à ces calculs, les possibilités de choix des valeurs de D et de N pour des valeurs de $\alpha$ et $F_{ref}$ données ne dépendent que de n. Pour n = 32 par exemple, D peut aller jusqu'à $2^{31}$-1 (idem pour N), là où un dispositif de synthèse de fréquence à division entière classique a des valeurs de D limitées à 100 ou 1000. Comme le montre la figure 7, qui illustre la résolution en fréquence en fonction du nombre de bits de D pour $F_{ref}$ = 20 MHz, il s'agit d'une augmentation importante de la résolution en fréquence des variations possibles $F_{ref}/D$ du facteur multiplicatif $\alpha$ que peut atteindre un dispositif selon l'invention en fonction de n. La résolution d'un dispositif de synthèse de fréquence à pas fractionnaires peut même être dépassée. Par exemple, pour un signal de référence de 10 MHz et n = 32, la résolution en fréquence est meilleure que 0,005 Hz.

Réciproquement, pour une résolution en fréquence donnée, puisqu'elle est égale à $F_{ref}/D$, il est possible d'augmenter $F_{ref}$ avec D. Cette possibilité est intéressante pour abaisser la contribution du signal de référence au bruit de phase en sortie dans la bande-passante du dispositif de synthèse de fréquence. En effet dans un tel dispositif, cette contribution est directement due à la fonction de multiplication de la fréquence de référence par le facteur multiplicatif a. Plus précisément, dans la bande-passante, la contribution du bruit de phase du signal de référence est augmentée de 20.log($\alpha$) en décibels. Il est alors avantageux de diminuer $\alpha$ et donc d'augmenter $F_{ref}$ pour $F_c$ donné.

La figure 8 représente schématiquement un dispositif 200 de synthèse de fréquence de type PLL, selon un deuxième mode de réalisation de l'invention. Ce dispositif 200 diffère du dispositif 100 en ce qu'il comporte un diviseur de fréquence 202, disposé dans la boucle de rétroaction 104 entre la sortie et le deuxième accumulateur de phase 122, et en ce que la valeur d'incrément de phase du premier accumulateur de phase 106 est adaptée en fonction de la valeur du facteur de division de ce diviseur de fréquence 202 pour un facteur d'asservissement souhaité de la fréquence de sortie $F_c$ à la fréquence de référence $F_{ref}$. Plus précisément, la valeur N est scindée en un produit de deux valeurs $N_a$ et $N_d$, N = $N_a.N_d$, $N_a$ représentant la valeur d'incrément de phase du premier accumulateur de phase 106 et $N_d$ le facteur de division du diviseur de fréquence 202. On conserve ainsi la relation $F_c$ = $\alpha.F_{ref}$ = N/D.$F_{ref}$ = $N_a.N_d$/D.$F_{ref}$. On notera enfin que le dispositif 200 diffère aussi du dispositif 100 en ce que le deuxième accumulateur de phase 122 n'est plus directement cadencé à la fréquence de sortie $F_c$, mais à la fréquence réduite $F_c/N_d$ qui reste toutefois liée à $F_c$.

L'avantage de ce deuxième mode de réalisation par rapport au précédent est d'éviter une trop grande différence entre les valeurs d'incréments de phases des deux accumulateurs de phases 106 et 122 en scindant la valeur de N en deux facteurs entiers. En effet, sachant qu'il est souvent souhaité d'avoir un facteur multiplicatif $\alpha$ largement supérieur

à 1, la valeur de N est souvent largement supérieure à celle de D, de sorte que, selon le calcul effectué précédemment en référence aux deux premiers modes de réalisation des figures 1 et 3, le nombre minimal $n = \text{ENT}[\log_2(\text{MAX}(N-1,D-1))] + 2$ est toujours dominé par la valeur de N et pas par celle de D. De la sorte, un certain nombre de bits d'implémentation de la valeur D restent inutiles et ce d'autant plus que le facteur $\alpha$ est grand. Or des bits d'implémentation inutiles signifient autant de portes logiques qui consomment de la puissance inutilement.

Dans le deuxième mode de réalisation de la figure 8, le calcul de n devient :

[Math. 3]

$$n = \text{ENT}\left[\log_2\left(\text{MAX}(N_a - 1, D - 1)\right)\right] + 2.$$

Puisque $N_a$ est inférieur à N, on réduit le nombre de bits d'implémentation inutiles. De façon avantageuse, on peut même choisir le facteur de division $N_d$ de telle sorte que, pour un facteur d'asservissement souhaité de la fréquence de sortie à la fréquence de référence, $\alpha = N/D$, la valeur d'incrément de phase D du deuxième accumulateur de phase 122 puisse être aussi proche que possible de la valeur d'incrément de phase $N_a$ du premier accumulateur de phase 106 tout en restant inférieure ou égale à cette dernière. Dans ce cas, peu de bits d'implémentation sont inutiles et l'architecture est optimisée en termes de consommation de puissance. Les fréquences d'horloge $F_{ref}$ et $F_c/N_d$ des deux accumulateurs de phases 106 et 122 deviennent également proches l'une de l'autre, celle du deuxième accumulateur de phase 122 étant ralentie de manière à réduire encore la consommation. Cette réduction n'est par ailleurs pas compensée par l'ajout du diviseur de fréquence 202. L'optimum est atteint pour $\text{ENT}[\log_2(N_a - 1)] = \text{ENT}[\log_2(D - 1)] = n - 2$. Il n'est toutefois pas intéressant que la valeur $N_a$ soit inférieure à D, parce que dans ce cas la première fréquence parasite dans le spectre de sortie ne serait plus $F_{ref}$ mais $F_c/N_d$. Il en résulterait alors, soit une dégradation du temps $\Delta t$ d'établissement du régime de fonctionnement, soit une dégradation de l'atténuation des fréquences parasites, selon la fréquence de coupure choisie pour le filtre de boucle 118.

La contrepartie de cette amélioration en consommation est une perte de résolution en fréquence qui devient $F_{ref}.N_d/D$ et non plus $F_{ref}/D$. Elle est donc dégradée d'un facteur $N_d$.

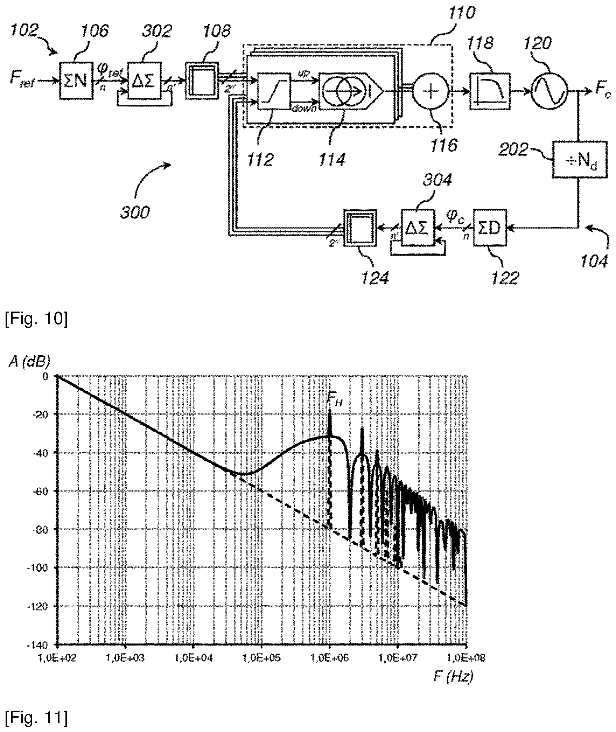

La figure 9 représente schématiquement un dispositif 300 de synthèse de fréquence de type PLL, selon un troisième mode de réalisation de l'invention. Ce dispositif 300 diffère du dispositif 200 en ce que chaque convertisseur multi-phases 108 ou 124 est précédé d'un dispositif de réduction de dynamique par quantification. Plus précisément, cette réduction de dynamique est par exemple réalisée à l'aide d'un quantificateur à modulation Delta-Sigma. Ainsi, un premier quantificateur à modulation Delta-Sigma 302 est disposé entre le premier accumulateur de phase 106 et le premier convertisseur multi-phases 108. De même, un deuxième quantificateur à modulation Delta-Sigma 304 est disposé entre le deuxième accumulateur de phase 122 et le deuxième convertisseur multi-phases 124.

Ce mode de réalisation présente l'avantage de faciliter l'implémentation du bloc de comparaison de phases 110 en diminuant le nombre de signaux logiques à traiter. En effet, sans réduction de dynamique par quantification, pour des valeurs de phases accumulées codées sur n bits en sortie des accumulateurs de phases, le nombre de comparateurs de phases 112 et de pompes de charge 114 est de $T = 2^n$ pour traiter les $2T = 2^{n+1}$ signaux issus des convertisseurs multi-phases 108 et 124. Ce nombre peut devenir très grand lorsque n augmente, c'est-à-dire lorsque la résolution en fréquence est grande.

Ainsi, la réduction de dynamique permet une réduction du nombre de bits pris en considération dans les convertisseurs multi-phases, rendant le nombre de signaux logiques qu'ils produisent moins élevé et le bloc de comparaison de phases 110 qui les reçoit plus simple à réaliser.

D'une façon générale, pour diminuer le nombre de bits fournis en entrée des convertisseurs multi-phases, la solution la plus simple consiste à tronquer les valeurs à convertir sur un nombre de bits n' inférieur à n en supprimant les bits de poids faibles. Cette troncature est mathématiquement équivalente à une nouvelle quantification des données numériques. Cette quantification produit une erreur qui est en général assimilée à un bruit, dit bruit de quantification. Ce bruit possède un spectre assez aléatoire mais qu'on approche souvent par un spectre plat de bruit blanc. Les convertisseurs multi-phases n'ont alors besoin que de convertir n' bits en $2^{n'}$ signaux logiques au prix de parasites assimilables à du bruit supplémentaire dans le spectre de sortie du dispositif de synthèse de fréquence. Du fait de l'asservissement en fréquence, ce bruit se retrouve principalement autour de la fréquence de coupure du dispositif, son écart-type diminuant lorsque n' augmente.

L'intérêt d'utiliser un quantificateur à modulation Delta-Sigma pour réaliser la réduction de dynamique est de réduire ce bruit de quantification, du fait que le bloc de comparaison de phases 110 est suivi d'un filtre passe-bas, en l'occurrence le filtre de boucle 118. En effet, la fonction de modulation Delta-Sigma déforme le spectre du bruit de quantification en engendrant moins de bruit à basse fréquence et plus de bruit à haute fréquence proche de $F_{ref}$ et $F_c/N_d$. Ce bruit est alors mieux filtré par le filtre de boucle 118 si les fréquences $F_{ref}$ et $F_c/N_d$ sont suffisamment grandes devant la fréquence de coupure du dispositif. On notera qu'en pratique l'ordre du filtre doit être strictement supérieur à celui de la modulation Delta-Sigma. Dans ce troisième mode de réalisation, le filtre de boucle 118 est donc au minimum d'ordre 2, sachant qu'en outre il ne peut pas être d'ordre trop élevé, c'est-à-dire qu'il reste avantageusement d'ordre inférieur ou égal à 3.

A titre d'exemple non limitatif, un quantificateur à modulation Delta-Sigma d'ordre 1 est très simple à implémenter car il est toujours stable. Il peut être constitué d'un additionneur suivi d'un registre de n bits, dont la sortie est tronquée en prenant les n' bits de poids forts tandis que les (n - n') bits de poids faibles restants sont complétés par des 0 en poids forts pour obtenir une nouvelle donnée sur n bits en entrée. La valeur de la nouvelle donnée ainsi créée représente la fraction qui a été tronquée en sortie du registre. Cette valeur est additionnée à la donnée courante d'entrée sur n bits et le résultat enregistré dans le registre pour le cycle suivant. C'est de cette façon que le quantificateur à modulation Delta-Sigma n'efface jamais l'erreur de quantification, mais la reporte dans le temps.

La figure 10 illustre, selon une échelle logarithmique des fréquences, la réponse en fréquence d'un signal numérique résultant :

- d'une rampe de phase engendrée par un accumulateur de phase soumis à un signal d'horloge de fréquence $F_H$ égale à 1 MHz, et

- d'une réduction de dynamique par quantification réalisée en sortie de l'accumulateur à l'aide d'un quantificateur à modulation Delta-Sigma.

En plus d'être parasité par la fréquence $F_H$ et ses harmoniques, le spectre illustré sur cette figure présente un bruit de quantification reporté principalement autour de ses fréquences parasites, sans changement sensible aux fréquences basses si on le compare au spectre de la figure 5. Ce bruit est destiné à être filtré par le filtre de boucle 118, et ce d'autant mieux de $F_{ref}$ est grand par rapport à la fréquence de coupure du dispositif. Etant donné qu'un dispositif de synthèse de fréquence selon l'invention permet d'augmenter la fréquence de référence facilement à facteur multiplicatif $\alpha$ constant, il se démarque, aussi du point de vue de l'utilisation d'une modulation Delta-Sigma, d'un dispositif de synthèse de fréquence à pas fractionnaires dans lequel cette fréquence de référence est plus difficile à augmenter.

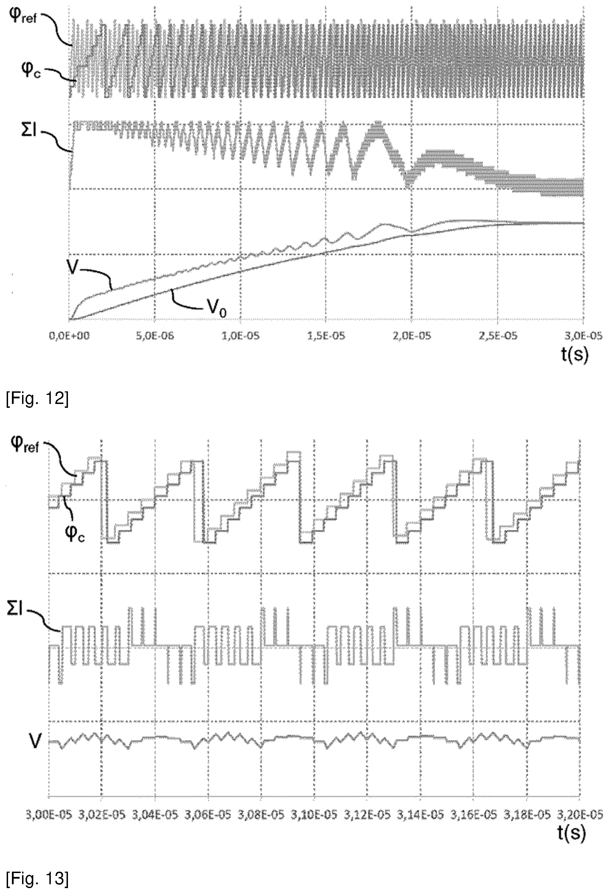

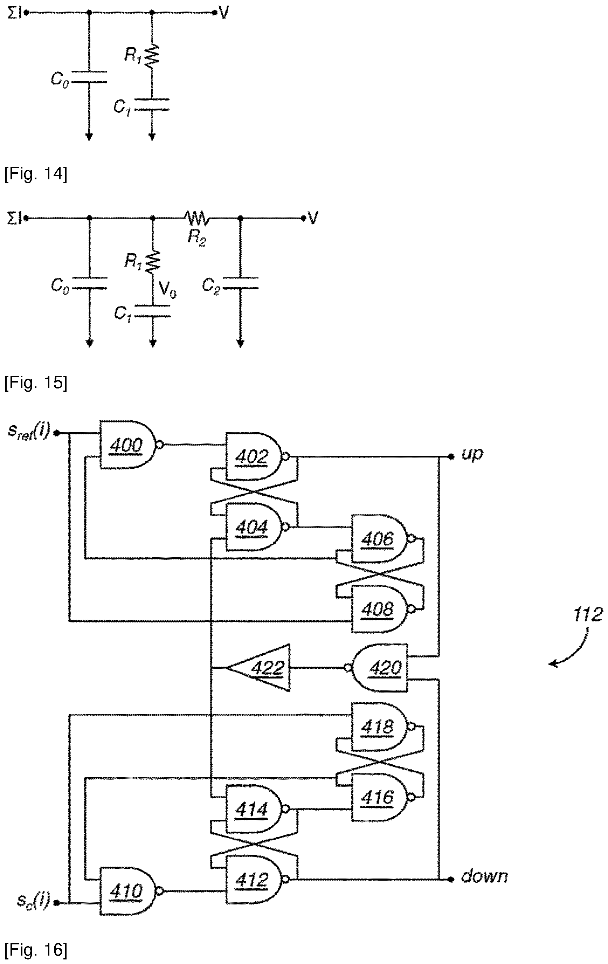

La figure 11 illustre trois chronogrammes de démarrage en régime transitoire du dispositif 100 de synthèse de fréquence, c'est-à-dire sans diviseur de fréquence 202 et sans quantificateur à modulation Delta-Sigma 302 ou 304, pour un ratio $\alpha = 3/2$, un filtre de boucle d'ordre 2 et T = 16. Le premier chronogramme montre l'évolution des valeurs d'accumulation de phases $\varphi_{ref}$ et $\varphi_c$ dont les rampes finissent par se synchroniser avant $3.10^{-5}$ secondes. Le deuxième chronogramme montre la stabilisation du courant sommé $\Sigma I$ en sortie du sommateur de courants 116 dans le même temps. Le troisième chronogramme montre la convergence de la tension analogique V fournie par le filtre de boucle 118 à l'oscillateur VCO 120 vers une valeur de stabilisation dans le même temps. La tension $V_0$ est une tension interne du filtre de boucle 118 qui est indiquée dans la figure 14.

La figure 12 illustre les trois mêmes chronogrammes en régime établi du dispositif 100 de synthèse de fréquence, c'est-à-dire à partir de $3.10^{-5}$ secondes, selon une échelle temporelle plus fine. On y remarque plus clairement la synchronisation des rampes de phases ($\varphi_{ref}$ et $\varphi_c$, ainsi que la convergence stabilisée de $\Sigma I$ et V. Les petites variations restantes correspondent aux parasites résiduels des fréquences d'horloges $F_{ref}$ et $F_c$ après filtrage par le filtre de boucle 118.

Il apparaît clairement qu'un dispositif de synthèse de fréquence tel que l'un de ceux décrits précédemment comporte au moins une partie des avantages suivants, celui du troisième mode de réalisation détaillé ci-dessus les cumulant tous :

- une grande résolution en fréquence du réglage du signal de sortie peut être atteinte et n'est pratiquement pas tributaire de la fréquence de référence,

- contrairement aux dispositifs de synthèse de fréquence à pas fractionnaires, cette grande résolution en fréquence n'est pas obtenue au détriment d'un bruit de phase injecté dans le signal de sortie,

- il se comporte comme un dispositif de synthèse de fréquence à division entière classique avec une fonction de transfert très proche, de sorte que son étude en est simplifiée,

- la fréquence $F_{ref}$ du signal de référence peut être aussi grande que souhaitée, sa contribution au bruit de phase total en sortie, $20.10g(\alpha)$, étant diminuée d'autant pour une fréquence de sortie $F_c$ donnée,

- les signaux parasites présents dans le spectre de sortie sont décalés vers les hautes fréquences, de sorte qu'ils sont mieux filtrés par le filtre de boucle,

- sa fréquence de coupure peut être augmentée dans les limites de la stabilité, de sorte que le temps d'établissement de son régime de fonctionnement peut être diminué,

- la résolution en fréquence ne dépend pas du nombre T de comparateurs de phases 112 et pompes de charge 114 utilisés dans le bloc de comparaison de phases 110, et

- aucune soustraction de valeur de modulo et/ou synchronisation entre les accumulateurs de phases 106 et 122 n'est nécessaire.

En termes d'application industrielle, l'un quelconque des dispositifs décrits précédemment peut être intégré dans tout dispositif nécessitant une synthèse de fréquence, comme par exemple un récepteur ou émetteur radiofréquence, une horloge de cadencement de circuits numériques, analogiques ou mixtes (i.e. analogiques et numériques), un système de mesure cadencé, une base de temps, etc.

On va maintenant donner des exemples concrets d'architectures électroniques pour chacun des éléments fonctionnels constitutifs des dispositifs de synthèse de fréquence décrits précédemment.

La figure 13 illustre un exemple de filtre d'ordre 1 pouvant être choisi pour réaliser le filtre de boucle 118 de l'un ou l'autre des dispositifs de synthèse de fréquence des figures 1 et 8. Ce filtre d'ordre 1 reçoit en entrée le courant analogique sommé $\Sigma I$ de la part du bloc de comparaison de phases 110 et fournit en sortie la tension de commande analogique V à l'oscillateur VCO 120. Il comporte en outre un premier circuit capacitif $C_0$ reliant l'entrée à la masse pour réaliser une fonction d'intégration en insérant un pôle à la fréquence nulle (PLL de type II). Il comporte en outre un deuxième circuit résistif et capacitif $R_1$, $C_1$ reliant la sortie à la masse pour créer une marge de phase en insérant un zéro à basse fréquence. Ce filtre d'ordre 1 ne peut pas être utilisé dans le dispositif de synthèse de fréquence de la figure 9 puisqu'il ne peut pas être d'ordre strictement supérieur à celui des quantificateurs Delta-Sigma 302 et 304.

La figure 14 illustre un exemple de filtre d'ordre 2 pouvant être choisi pour réaliser le filtre de boucle 118 de l'un quelconque des dispositifs de synthèse de fréquence des figures 1, 8 et 9. Ce filtre d'ordre 2 diffère du filtre de la figure 13 en ce qu'un troisième circuit résistif $R_2$ s'interpose entre le deuxième circuit $R_1$, $C_1$ et la sortie, et en ce qu'un quatrième circuit capacitif $C_2$ relie la sortie à la masse. Ces deux circuits supplémentaires ajoutent un pôle au-delà de la fréquence de coupure du filtre.

La figure 15 représente schématiquement l'architecture générale, en termes de portes logiques, d'un exemple de comparateur de phases 112 adapté pour le dispositif de synthèse de fréquence de la figure 1, 8 ou 9.

Ce comparateur de phases comporte une première entrée de comparaison qui reçoit l'un des T premiers signaux logiques fournis par le premier convertisseur multi-phases 108. Ce signal est noté $s_{ref}(i)$, avec $0 \le i < T$, et son niveau logique est mis à jour à la fréquence $F_{ref}$. Le comparateur comporte une deuxième entrée de comparaison qui reçoit l'un des T deuxièmes signaux logiques fournis par le deuxième convertisseur multi-phases 124, plus précisément celui de même indice que $s_{ref}(i)$. Ce signal est noté $s_c(i)$ et son niveau logique est mis à jour à la fréquence $F_c$ (ou $F_c/N_d$)-

Le premier signal logique $s_{ref}(i)$ est reçu en entrée d'une porte logique NON-ET 400 dont la sortie est fournie en entrée d'une porte logique NON-ET 402 d'une première bascule RS à deux portes logiques NON-ET 402 et 404. La sortie de la porte logique NON-ET 402 fournit le signal « up » du comparateur de phases 112 et est en outre retournée en entrée de la porte logique NON-ET 404. La sortie de la porte logique NON-ET 404 est fournie en entrée d'une porte logique NON-ET 406 d'une deuxième bascule RS à deux portes logiques NON-ET 406 et 408 et est en outre retournée en entrée de la porte logique NON-ET 402. La sortie de la porte logique NON-ET 406 est retournée en entrée de la porte logique NON-ET 408. La sortie de la porte logique NON-ET 408 est retournée en entrée de la porte logique NON-ET 406 et est en outre fournie en entrée de la porte logique NON-ET 400. Enfin, le premier signal logique $s_{ref}(i)$ est également reçu en entrée de la porte logique NON-ET 408.

Le deuxième signal logique $s_c(i)$ est reçu en entrée d'une porte logique NON-ET 410 dont la sortie est fournie en entrée d'une porte logique NON-ET 412 d'une troisième bascule RS à deux portes logiques NON-ET 412 et 414. La sortie de la porte logique NON-ET 412 fournit le signal « down » du comparateur de phases 112 et est en outre retournée en entrée de la porte logique NON-ET 414. La sortie de la porte logique NON-ET 414 est fournie en entrée d'une porte logique NON-ET 416 d'une quatrième bascule RS à deux portes logiques NON-ET 416 et 418 et est en outre retournée en entrée de la porte logique NON-ET 412. La sortie de la porte logique NON-ET 416 est retournée en entrée de la porte logique NON-ET 418. La sortie de la porte logique NON-ET 418 est retournée en entrée de la porte logique NON-ET 416 et est en outre fournie en entrée de la porte logique NON-ET 410. Enfin, le deuxième signal logique $s_c(i)$ est également reçu en entrée de la porte logique NON-ET 418.

Les signaux « up » et « down » sont en outre fournis en entrée d'une porte logique NON-ET 420 dont la sortie est fournie en entrées des portes logiques NON-ET 404 et 414 via une porte logique OUI 422 (équivalente à une double porte logique NON).

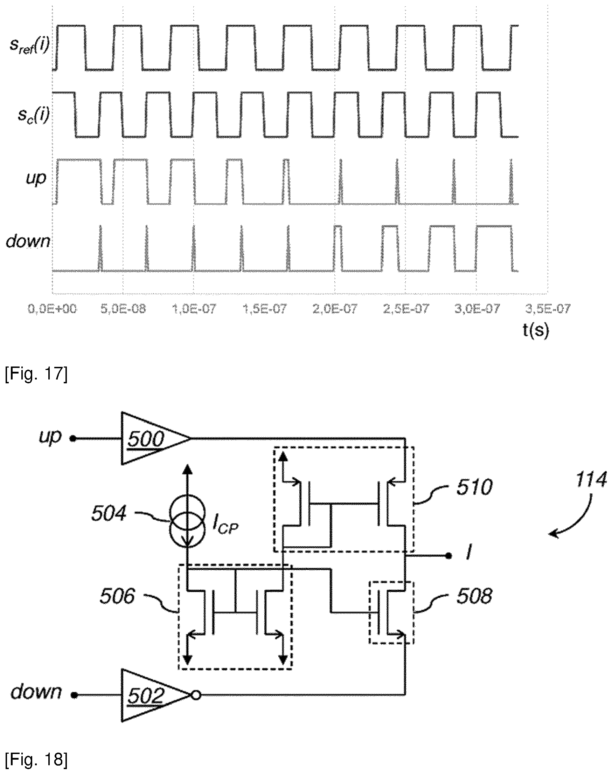

La figure 16 illustre un exemple de chronogramme résultant dans lequel $F_{ref} = 25$ MHz et $F_c = 30$ MHz. Dans ce type de comparateur, l'erreur de phase mesurée est proportionnelle à la largeur des impulsions engendrées sur les signaux « up » et « down ».

La figure 17 représente schématiquement l'architecture générale d'un exemple de pompe de charge 114 adaptée pour le dispositif de synthèse de fréquence de la figure 1, 8 ou 9.

Elle reçoit le signal « up » en entrée d'une porte logique OUI 500, le signal « down » en entrée d'une porte logique NON 502 et est polarisée par un générateur de courant $I_{CP}$ 504. Ce générateur de courant $I_{CP}$ 504 alimente un premier miroir de courant 506 à deux transistors n-MOS qui recopie le courant $I_{CP}$ sur un transistor n-MOS de sortie 508. Il alimente également un deuxième miroir de courant 510 à deux transistors p-MOS dont l'un, dit de sortie, est relié par son drain à la sortie de la porte logique OUI 500. Le drain du transistor n-MOS de sortie 508 est relié à la sortie de la porte logique NON 502. Le courant de sortie I est pris entre le transistor n-MOS de sortie 508 et le transistor p-MOS de sortie du deuxième miroir de courant 510.

En fonctionnement, le courant $I_{CP}$ est recopié par le premier miroir de courant 506 sur le transistor n-MOS de sortie 508 lorsqu'il est activé, c'est-à-dire lorsque le signal « down » est au niveau « 1 », et sur le transistor p-MOS de sortie du deuxième miroir de courant 510 lorsqu'il est activé, c'est-à-dire lorsque le signal « up » est au niveau « 1 ». Lorsque les signaux « up » et « down » sont tous les deux au niveau « 1 » en même temps, les courants des transistors n-MOS et p-MOS de sortie s'annulent en sortie I.

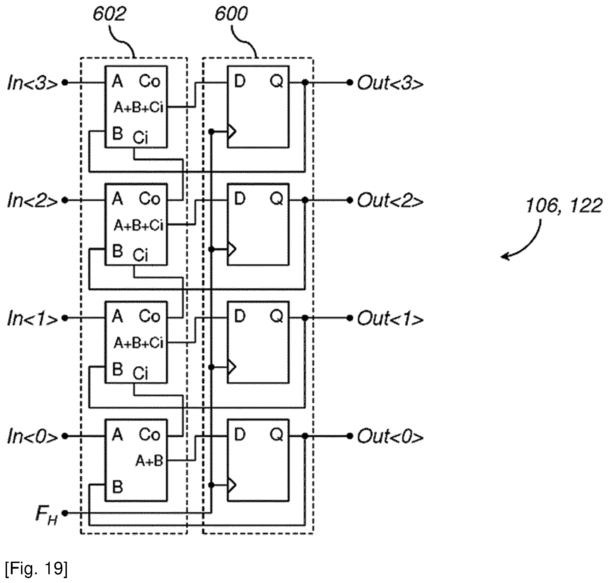

La figure 18 représente schématiquement l'architecture générale d'un exemple d'accumulateur de phase 106 ou 122 adapté pour le dispositif de synthèse de fréquence de la figure 1 ou 8. Cet exemple est en particulier adapté à un cas précis selon lequel les valeurs d'incréments de phase N (ou $N_a$) et D sont codées sur 4 bits et les registres In, Out occupent 4 bits de mémoire. Le registre d'entrée In mémorise la valeur de configuration N (ou $N_a$) pour l'accumulateur de phase 106 et la valeur de configuration D pour l'accumulateur de phase 122.

Cette architecture comporte un registre de mémorisation 600 à quatre bascules synchrones cadencées par la fréquence d'horloge $F_H$ ($F_{ref}$ pour l'accumulateur de phase 106 et $F_c$ pour l'accumulateur de phase 122). Les quatre sorties binaires de ce registre 600 alimentent les quatre bits Out<0>, Out<1 >, Out<2>, Out<3> du registre de sortie Out. Les quatre entrées binaires de ce registre 600 sont alimentées par un additionneur 4 bits 602 à quatre modules d'additions binaires reliés entre eux de façon classique pour réaliser une addition sur 4 bits. Les quatre bits In<0>, In<1>, In<2>, In<3> du registre d'entrée In alimentent quatre entrées respectives des modules d'additions binaires de l'additionneur 602, lesquels reçoivent également les quatre sorties binaires du registre de mémorisation 600 pour réaliser l'opération d'accumulation. Les sorties des quatre modules d'additions binaires sont fournies aux entrées respectives des quatre bascules synchrones du registre de mémorisation 600. On remarque que la fonction modulo de chaque accumulateur de phase 106, 122 se réalise implicitement en n'utilisant pas la retenue de l'additionneur de poids fort.

L'architecture de chaque accumulateur de phase 106 ou 122 est ainsi largement simplifiée par rapport à celle qui doit être envisagée dans le document de brevet US 9,509,320 B2.

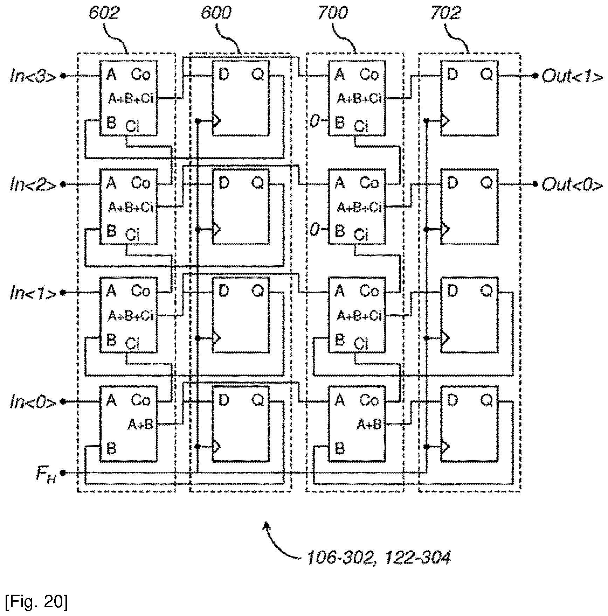

La figure 19 représente schématiquement l'architecture générale d'un exemple d'accumulateur de phase 106 ou 122 combiné avec un quantificateur Delta-Sigma 302 ou 304, adapté pour le dispositif de synthèse de fréquence de la figure 9. Cet exemple est en particulier adapté au cas précis selon lequel les valeurs d'incréments de phase N (ou $N_a$) et D sont codées sur 4 bits et le registre In occupe 4 bits de mémoire. Le registre d'entrée In mémorise la valeur de configuration N (ou $N_a$) pour l'accumulateur de phase 106 et la valeur de configuration D pour l'accumulateur de phase 122.

Conformément à cet exemple, la fonction d'accumulation de phase est réalisée par le registre de mémorisation 600 et l'additionneur 4 bits 602, disposés comme précédemment dans l'exemple de la figure 18. La fonction de réduction de dynamique à l'aide d'un quantificateur à modulation Delta-Sigma est réalisée par un additionneur 4 bits supplémentaire 700 et par un registre de mémorisation supplémentaire 702, ces deux modules s'interposant entre le registre de mémorisation 600 et la sortie Out réduite à 2 bits.

Plus précisément, l'additionneur supplémentaire 700 comporte quatre modules d'additions binaires reliés entre eux de façon classique pour réaliser une addition sur 4 bits. Les quatre bits de sortie de l'additionneur 602 alimentent quatre entrées respectives des modules d'additions binaires de l'additionneur supplémentaire 700, lesquels reçoivent également soit des 0, soit des sorties du registre de mémorisation supplémentaire 702 en fonction de la réduction de dynamique souhaitée.

Par exemple, pour obtenir le registre de sortie Out sur 2 bits Out<0>, Out<1>, le registre de mémorisation supplémentaire 702 comporte quatre bascules synchrones cadencées par la fréquence d'horloge $F_H$, parmi lesquelles :

- les deux premières bascules synchrones relatives aux deux bits de poids les plus faibles reçoivent les sorties respectives des deux modules d'additions binaires de ces deux bits pour leur refournir ces valeurs en entrée au coup d'horloge suivant, et

- les deux bascules synchrones suivantes relatives aux deux bits de poids les plus forts reçoivent les sorties respectives des deux modules d'additions binaires de ces deux bits pour fournir en sortie des valeurs destinées au registre Out.

Les deux modules d'additions binaires relatifs aux deux bits de poids les plus forts reçoivent des 0.

Le bit Out<1> est déterminé par la sortie de la quatrième bascule synchrone du registre de mémorisation supplémentaire 702.

Enfin, le bit Out<0> est déterminé par la sortie de la troisième bascule synchrone du registre de mémorisation supplémentaire 702.

On obtient ainsi un quantificateur sur 2 bits à modulation Delta-Sigma d'ordre 1 toujours stable. Les deux bits de poids forts qui ont été tronqués représentent la sortie arrondie et sont remplacés par des zéros sur les entrées correspondantes de l'additionneur supplémentaire 700. Pour ces bits, l'addition ne consiste ainsi qu'à additionner et propager la retenue du bit de poids inférieur. De cette façon le résultat est la somme de la valeur de phase accumulée courante sur 4 bits et de la fraction sur 2 bits soustraite au résultat précédent retardé d'une période d'horloge. Il s'agit bien de la somme intégrale de l'erreur de quantification, ce qui est le principe d'une modulation Delta-Sigma. Lorsque l'on utilise une telle architecture pour implémenter les quantificateurs à modulation Sigma-Delta 302 et 304, il est avantageux utiliser l'architecture de la figure 14 pour implémenter le filtre de boucle 118.

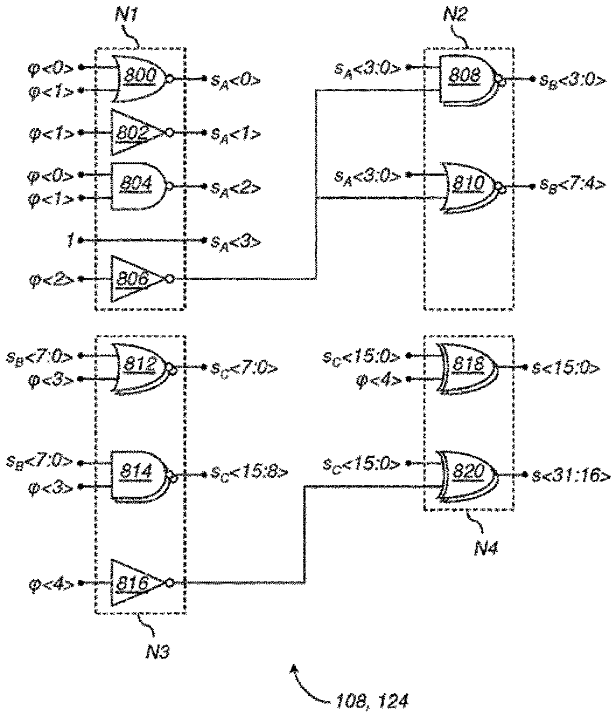

La figure 20 représente schématiquement l'architecture générale, en termes de portes logiques, d'un exemple de convertisseur multi-phases 108 ou 124 adapté pour le dispositif de synthèse de fréquence de la figure 1, 8 ou 9. Cet exemple est en particulier adapté au cas précis selon lequel les valeurs d'accumulation de phase sont codées sur n ou n' = 5 bits pour un nombre $T = 2^5 = 32$ de signaux logiques en sortie du convertisseur, selon la matrice de correspondance suivante :

[Tableau 2]

| φ | s <31:0> |
|---|---|
| 0 | 11111111111111110000000000000000 |
| 1 | 11111111111111100000000000000001 |
| 2 | 11111111111111000000000000000011 |
| 3 | 11111111111110000000000000000111 |
| 4 | 11111111111100000000000000001111 |
| 5 | 11111111111000000000000000011111 |
| 6 | 11111111110000000000000000111111 |
| 7 | 11111111100000000000000001111111 |
| 8 | 11111111000000000000000011111111 |
| 9 | 11111110000000000000000111111111 |
| 10 | 11111100000000000000001111111111 |
| 11 | 11111000000000000000011111111111 |
| 12 | 11110000000000000000111111111111 |
| 13 | 11100000000000000001111111111111 |
| 14 | 11000000000000000011111111111111 |
| 15 | 10000000000000000111111111111111 |
| 16 | 00000000000000000111111111111111 |
| 17 | 00000000000000001111111111111110 |
| 18 | 00000000000000011111111111111100 |
| 19 | 00000000000000111111111111111000 |
| 20 | 00000000000001111111111111110000 |
| 21 | 00000000000011111111111111100000 |
| 22 | 00000000000111111111111111000000 |
| 23 | 00000000001111111111111110000000 |
| 24 | 00000000011111111111111100000000 |

(suite)

| φ | s <31:0> |
|---|---|
| 25 | 00000000111111111111111000000000 |
| 26 | 00000001111111111111110000000000 |
| 27 | 00000011111111111111100000000000 |
| 28 | 00001111111111111111000000000000 |
| 29 | 00011111111111111110000000000000 |
| 30 | 00111111111111111100000000000000 |
| 31 | 01111111111111111000000000000000 |

On note φ<4:0> l'une des T = 32 valeurs d'accumulation de phase possibles codée en binaire sur ln(T)/ln(2) = 5 bits φ<0> à φ<4> et s<31:0> les 32 signaux logiques résultants.

A un premier niveau N1 du convertisseur multi-phases 108 ou 124, une porte logique NON-OU 800 reçoit les bits φ<0> et φ<1> pour fournir une valeur logique d'un signal logique intermédiaire $s_A$<0>. Une porte logique NON 802 reçoit le bit φ<1> pour fournir une valeur logique d'un signal logique intermédiaire $s_A$<1>. Une porte logique NON-ET 804 reçoit les bits φ<0> et φ<1> pour fournir une valeur logique d'un signal logique intermédiaire $s_A$<2>. Une valeur logique d'un signal logique intermédiaire $s_A$<3> est mise à « 1 ». Une porte logique NON 806 reçoit le bit φ<2>.

A un deuxième niveau N2 du convertisseur multi-phases 108 ou 124, quatre portes logiques NON-ET 808 reçoivent respectivement les quatre valeurs logiques des quatre signaux logiques intermédiaires $s_A$<3:0> et la sortie de la porte logique NON 806 pour fournir respectivement quatre valeurs logiques de quatre signaux logiques intermédiaires $s_B$<3:0>. Quatre portes logiques NON-OU 810 reçoivent respectivement les quatre valeurs logiques des quatre signaux logiques intermédiaires $s_A$<3:0> et la sortie de la porte logique NON 806 pour fournir respectivement quatre valeurs logiques de quatre signaux logiques intermédiaires $s_B$<7:4>.

A un troisième niveau N3 du convertisseur multi-phases 108 ou 124, huit portes logiques NON-OU 812 reçoivent respectivement les huit valeurs logiques des huit signaux logiques intermédiaires $s_B$<7:0> et le bit φ<3> pour fournir respectivement huit valeurs logiques de huit signaux logiques intermédiaires $s_C$<7:0>. Huit portes logiques NON-ET 814 reçoivent respectivement les huit valeurs logiques des huit signaux logiques intermédiaires $s_B$<7:0> et le bit φ<3> pour fournir respectivement huit valeurs logiques de huit signaux logiques intermédiaires $s_C$<15:8>. Une porte logique NON 816 reçoit le bit φ<4>.

Enfin, à un quatrième niveau N4 du convertisseur multi-phases 108 ou 124, seize portes logiques OU-EXCLUSIF 818 reçoivent respectivement les seize valeurs logiques des seize signaux logiques intermédiaires $s_C$<15:0> et le bit φ<4> pour fournir respectivement les seize valeurs logiques des seize signaux logiques s<15:0>. Seize autres portes logiques OU-EXCLUSIF 820 reçoivent respectivement les seize valeurs logiques des seize signaux logiques intermédiaires $s_C$<15:0> et la sortie de la porte logique NON 816 pour fournir respectivement les seize valeurs logiques des seize signaux logiques s<31:16>.

En ce qui concerne les architectures générales de l'oscillateur à fréquence contrôlée 120 et du diviseur de fréquence 202, elles sont bien connues et ne seront pas détaillées. L'oscillateur 120 est par exemple un oscillateur commandé en tension formé d'une inductance mise en parallèle avec deux varactors disposés tête-bêche et de deux transistors NMOS dont les grilles sont montées tête-bêche de manière à engendrer un gain suffisant pour amorcer puis entretenir l'oscillation aux bornes de l'inductance, ces transistors étant polarisés grâce au courant issu de l'alimentation du point milieu de l'inductance.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué,

## Revendications

1. Dispositif (100 ; 200 ; 300) de synthèse de fréquence à boucle de rétroaction comportant :

- une entrée destinée à recevoir un signal électrique oscillant à une fréquence de référence ($F_{ref}$) ;
- une sortie destinée à fournir un signal électrique oscillant à une fréquence de sortie ($F_c$) ;
- un circuit (102) d'asservissement de la fréquence de sortie ($F_c$) à la fréquence de référence ($F_{ref}$), reliant l'entrée à la sortie du dispositif et comportant un premier accumulateur de phase (106) cadencé à une fréquence liée à la fréquence de référence ($F_{ref}$), un bloc de comparaison de phases (110), un filtre de boucle (118) et un oscillateur (120) à fréquence contrôlée fournissant le signal électrique oscillant à la fréquence de sortie ($F_c$), le bloc de comparaison de phases (110) étant lié au filtre de boucle pour contrôler ledit oscillateur (120) à fréquence contrôlée ; et
- une boucle de rétroaction (104) reliant la sortie au bloc de comparaison de phases (110), comportant un deuxième accumulateur de phase (122) cadencé à une fréquence liée à la fréquence de sortie ($F_c$), les premier et deuxième accumulateurs de phase (106, 122) étant aptes à fournir un même nombre T de valeurs discrètes d'accumulation de phase possibles ;

**caractérisé en ce que** :

- le circuit d'asservissement (102) est configuré pour fournir, au bloc de comparaison de phases (110), T premiers signaux logiques distincts dont les niveaux logiques dépendent continument des valeurs d'accumulation de phase ($\varphi_{ref}$) fournies par le premier accumulateur de phase (106) selon une première matrice de correspondance multi-phases entre les T valeurs discrètes d'accumulation de phase possibles et les T premiers signaux ;
- la boucle de rétroaction (104) est configurée pour fournir, au bloc de comparaison de phases (110), T deuxièmes signaux logiques distincts dont les niveaux logiques dépendent continument des valeurs d'accumulation de phase ($\varphi_c$) fournies par le deuxième accumulateur de phase (122) selon une deuxième matrice de correspondance multi-phases entre les T valeurs discrètes d'accumulation de phase possibles et les T deuxièmes signaux ; et
- le bloc de comparaison de phases (110) comporte T comparateurs de phases (112) à portes logiques recevant respectivement en temps continu les T premiers signaux logiques sur T premières entrées de comparaison et les T deuxièmes signaux logiques sur T deuxièmes entrées de comparaison.

2. Dispositif (100 ; 200 ; 300) de synthèse de fréquence selon la revendication 1, dans lequel :

- le circuit d'asservissement (102) comporte un premier convertisseur multi-phases (108) entre le premier accumulateur de phase (106) et le bloc de comparaison de phases (110), configuré pour implémenter la première matrice de correspondance multi-phases ; et
- la boucle de rétroaction (104) comporte un deuxième convertisseur multi-phases (124) entre le deuxième accumulateur de phase (122) et le bloc de comparaison de phases (110), configuré pour implémenter la deuxième matrice de correspondance multi-phases.

3. Dispositif (100 ; 200 ; 300) de synthèse de fréquence selon la revendication 2, dans lequel chacun des premier et deuxième convertisseurs multi-phases (108, 124) implémente sa matrice de correspondance multi-phases sous la forme d'un ensemble de portes logiques (800 à 820) recevant en entrée une valeur courante d'accumulation de phase codée en binaire sur ln(T)/ln(2) bits, où ln(.) est la fonction logarithme népérien, et fournissant en sortie T valeurs courantes de niveaux logiques.

4. Dispositif (100 ; 200 ; 300) de synthèse de fréquence selon l'une quelconque des revendications 1 à 3, dans lequel chaque coefficient de chacune des première et deuxième matrices de correspondance multi-phases est soit à une première valeur binaire indicatrice d'un premier niveau logique de signal logique, soit à une deuxième valeur binaire indicatrice d'un deuxième niveau logique de signal logique.

5. Dispositif (100 ; 200 ; 300) de synthèse de fréquence selon la revendication 4, dans lequel chaque ligne ou colonne de chacune des première et deuxième matrices de correspondance multi-phases, lorsque cette ligne ou colonne indique les niveaux logiques que doit prendre l'un des T premiers ou deuxièmes signaux logiques pour les T valeurs discrètes d'accumulation de phase possibles, ne présente circulairement par modulo T qu'une seule transition de la première valeur binaire vers la deuxième valeur binaire pour une première moitié des T valeurs discrètes d'accumulation de phase possibles et qu'une seule transition de la deuxième valeur binaire vers la première valeur binaire pour une deuxième moitié des T valeurs discrètes d'accumulation de phase possibles.

6. Dispositif (100 ; 200 ; 300) de synthèse de fréquence selon la revendication 4 ou 5, dans lequel chaque ligne ou colonne de chacune des première et deuxième matrices de correspondance multi-phases, lorsque cette ligne ou colonne indique les niveaux logiques que doit prendre l'un des T premiers ou deuxièmes signaux logiques pour les T valeurs discrètes d'accumulation de phase possibles, ne diffère de celle qui la précède ou de celle qui la suit que par un décalage d'une colonne ou respectivement d'une ligne modulo T des valeurs de coefficients qu'elle contient, ce décalage restant dans le même sens de la première à la dernière ligne ou colonne.

**7.** Dispositif (100 ; 200 ; 300) de synthèse de fréquence selon l'une quelconque des revendications 1 à 6, dans lequel chacune des première et deuxième matrices de correspondance est symétrique.

**8.** Dispositif (100 ; 200 ; 300) de synthèse de fréquence selon l'une quelconque des revendications 1 à 7, dans lequel les première et deuxième matrices de correspondance sont identiques.

**9.** Dispositif (100 ; 200 ; 300) de synthèse de fréquence selon l'une quelconque des revendications 1 à 8, dans lequel le bloc de comparaison de phases (110) comporte T pompes de charge (114) recevant respectivement en temps continu T paires de signaux impulsionnels fournies par les T comparateurs de phases (112) et fournissant respectivement en temps continu T courants de sortie.

**10.** Dispositif (100 ; 200 ; 300) de synthèse de fréquence selon la revendication 9, dans lequel le bloc de comparaison de phases (110) comporte un sommateur de courants (116) recevant en parallèle les T courants de sortie fournis par les T pompes de charge (114) pour fournir un unique courant sommé en sortie du bloc de comparaison de phases (110).

**Patentansprüche**

**1.** Vorrichtung (100; 200; 300) zur Frequenzsynthese mit Rückkopplungsschleife, Folgendes beinhaltend:

- einen Eingang, der dazu bestimmt ist, ein elektrisches Signal zu empfangen, das auf einer Referenzfrequenz ($F_{ref}$) oszilliert;
- einen Ausgang, der dazu bestimmt ist, ein elektrisches Signal bereitzustellen, das auf einer Ausgangsfrequenz ($F_c$) oszilliert;
- eine Schaltung (102) zum Unterwerfen der Ausgangsfrequenz ($F_c$) auf die Referenzfrequenz ($F_{ref}$), die den Eingang mit dem Ausgang der Vorrichtung verbindet, und einen ersten Phasenakkumulator (106) beinhaltet, der auf eine mit der Referenzfrequenz ($F_{ref}$) verknüpfte Frequenz getaktet ist, einen Phasenvergleichsblock (110), einen Schleifenfilter (118) und einen Oszillator (120) mit kontrollierter Frequenz, der das elektrische Signal bereitstellt, das auf der Ausgangsfrequenz ($F_c$) oszilliert, wobei der Phasenvergleichsblock (110) mit dem Schleifenfilter verknüpft ist, um den Oszillator (120) mit kontrollierter Frequenz zu kontrollieren; und
- eine Rückkopplungsschleife (104), die den Ausgang mit dem Phasenvergleichsblock (110) verknüpft, die einen zweiten Phasenakkumulator (122) beinhaltet, der auf eine mit der Ausgangsfrequenz ($F_c$) verknüpfte Frequenz getaktet ist, wobei der erste und zweite Phasenakkumulator (106, 122) imstande sind, eine selbe Anzahl T an möglichen diskreten Phasenakkumulationswerten bereitzustellen;

**dadurch gekennzeichnet, dass**:

- die Schaltung zum Unterwerfen (102) konfiguriert ist, um dem Phasenvergleichsblock (110) T erste unterschiedliche logische Signale bereitzustellen, deren Logikpegel kontinuierlich von den Phasenakkumulationswerten ($\varphi_{ref}$) abhängig sind, die von dem ersten Phasenakkumulator (106) gemäß einer ersten Mehrphasen-Korrespondenz-Matrix zwischen den T möglichen diskreten Phasenakkumulationswerten und den T ersten Signalen bereitgestellt werden;
- die Rückkopplungsschleife (104) konfiguriert ist, um dem Phasenvergleichsblock (110) T zweite unterschiedliche logische Signale bereitzustellen, deren Logikpegel kontinuierlich von den Phasenakkumulationswerten ($\varphi_c$) abhängig sind, die von dem zweiten Phasenakkumulator (122) gemäß einer zweiten Mehrphasen-Korrespondenz-Matrix zwischen den T möglichen diskreten Phasenakkumulationswerten und den T zweiten Signalen bereitgestellt werden; und
- der Phasenvergleichsblock (110) T Phasenvergleicher (112) mit Logikgattern beinhaltet, die jeweils in kontinuierlicher Zeit die T ersten logischen Signale in T ersten Vergleichseingängen und die T zweiten logischen Signale in T zweiten Vergleichseingängen empfangen.

**2.** Vorrichtung (100; 200; 300) zur Frequenzsynthese nach Anspruch 1, wobei:

- die Schaltung zum Unterwerfen (102) einen ersten Mehrphasenwandler (108) zwischen dem ersten Phasenakkumulator (106) und dem Phasenvergleichsblock (110) beinhaltet, der konfiguriert ist, um die erste Mehrphasen-Korrespondenz-Matrix zu implementieren; und
- die Rückkopplungsschleife (104) einen zweiten Mehrphasenwandler (124) zwischen dem zweiten Phasenakkumulator (122) und dem Phasenvergleichsblock (110) beinhaltet, der konfiguriert ist, um die zweite Mehrphasen-Korrespondenz-Matrix zu implementieren.

**3.** Vorrichtung (100; 200; 300) zur Frequenzsynthese nach Anspruch 2, wobei jeder des ersten und zweiten Mehrphasenwandlers (108, 124) seine Mehrphasen-Korrespondenz-Matrix in Form einer Logikgattereinheit (800 bis 820) implementiert, die am Eingang einen laufenden Phasenakkumulationswert empfängt, der binär auf $\ln(T)/\ln(2)$ Bits codiert ist, wobei $\ln(.)$ die natürliche Logarithmusfunktion ist, und am Ausgang T laufende Logikpegelwerte bereitstellt.

**4.** Vorrichtung (100; 200; 300) zur Frequenzsynthese nach einem der Ansprüche 1 bis 3, wobei jeder Koeffizient jeder der ersten und zweiten Mehrphasen-Korrespondenz-Matrizen entweder auf einem ersten binären Wert ist, der auf einen ersten Logikpegel eines logischen Signals hinweist, oder auf einem zweiten binären Wert, der auf einen zweiten Logikpegel eines logischen Signals hinweist.

**5.** Vorrichtung (100; 200; 300) zur Frequenzsynthese nach Anspruch 4, wobei jede Zeile oder Spalte jeder der ersten und zweiten Mehrphasen-Korrespondenz-Matrizen, wenn diese Zeile oder Spalte auf die Logikpegel hinweist, die eines der ersten oder zweiten T logischen Signale für die möglichen T diskreten Phasenakkumulationswerte einnehmen muss, kreisförmig durch modulo T nur einen einzigen Übergang von dem ersten binären Wert auf den zweiten binären Wert für eine erste Hälfte der T möglichen diskreten Phasenakkumulationswerte, und nur einen einzigen Übergang von dem zweiten binären Wert auf den ersten binären Wert für eine zweite Hälfte der T möglichen diskreten Phasenakkumulationswerte aufweist.

**6.** Vorrichtung (100; 200; 300) zur Frequenzsynthese nach Anspruch 4 oder 5, wobei jede Zeile oder Spalte jeder der ersten und zweiten Mehrphasen-Korrespondenz-Matrizen, wenn diese Zeile oder Spalte auf die Logikpegel hinweist, den eines der ersten oder zweiten T logischen Signale für die möglichen T diskreten Phasenakkumulationswerte einnehmen muss, von jenem, der ihm vorausgeht oder jenem, der ihm nachfolgt, nur um den Versatz einer Spalte, oder jeweils um eine Zeile modulo T der Koeffizienten-Werte, die sie enthält, abweicht, wobei dieser Versatz in derselben Richtung von der ersten bis zur letzten Zeile oder Spalte verbleibt.

**7.** Vorrichtung (100; 200; 300) zur Frequenzsynthese nach einem der Ansprüche 1 bis 6, wobei jede der ersten und zweiten Korrespondenz-Matrizen symmetrisch ist.

**8.** Vorrichtung (100; 200; 300) zur Frequenzsynthese nach einem der Ansprüche 1 bis 7, wobei die erste und zweite Korrespondenz-Matrizen identisch sind.

**9.** Vorrichtung (100; 200; 300) zur Frequenzsynthese nach einem der Ansprüche 1 bis 8, wobei der Phasenvergleichsblock (110) T Ladepumpen (114) beinhaltet, die jeweils in kontinuierlicher Zeit T Impulssignalpaare empfängt, die von den T Phasenvergleichern (112) bereitgestellt werden, und jeweils in kontinuierlicher Zeit T Ausgangsströme bereitstellt.

**10.** Vorrichtung (100; 200; 300) zur Frequenzsynthese nach Anspruch 9, wobei der Phasenvergleichsblock (110) einen Summierer von Strömen (116) beinhaltet, der parallel die T Ausgangsströme empfängt, die die von den T Ladepumpen (114) bereitgestellt werden, um einen einzigen Strom bereitzustellen, der am Ausgang des Phasenvergleichsblocks (110) summiert wird.

**Claims**

**1.** A feedback-loop frequency synthesis device (100; 200; 300) comprising:

- an input intended to receive an electrical signal oscillating at a reference frequency ($F_{ref}$);
- an output intended to supply an electrical signal oscillating at an output frequency ($F_c$);
- a servo circuit (102) for the control of the output frequency ($F_c$) by the reference frequency ($F_{ref}$), connecting the input to the output of the device and comprising a first phase accumulator (106) clocked at a frequency linked to the reference frequency ($F_{ref}$), a phase comparison block (110), a loop filter (118) and a frequency controlled oscillator (120) providing the electrical signal oscillating at the output frequency ($F_c$), the phase comparison block (110) being linked to the loop filter for controlling said frequency controlled oscillator (120); and
- a feedback loop (104) connecting the output to the phase comparison block (110), comprising a second phase accumulator (122) clocked at a frequency linked to the output frequency ($F_c$), the first and second phase accumulators (106, 122) being adapted to provide the same number T of possible phase accumulation discrete values;

**characterized in that**:

- the servo circuit (102) is configured to provide, to the phase comparison block (110), T first distinct logic signals the logic levels of which depend continuously on the phase accumulation values ($\varphi_{ref}$) supplied by the first phase accumulator (106) according to a first multi-phase correspondence matrix between the T possible phase accumulation discrete values and the T first signals;
- the feedback loop (104) is configured to provide, to the phase comparison block (110), T second distinct logic signals the logic levels of which depend continuously on the phase accumulation values ($\varphi_c$) supplied by second phase accumulator (122) according to a second multi-phase correspondence matrix between the T possible phase accumulation discrete values and the T second signals; and
- the phase comparison block (110) comprises T phase comparators (112) with logic gates receiving respectively in continuous time the T first logic signals on T first comparison inputs and the T second logic signals on T second comparison inputs.

2. The frequency synthesis device (100; 200; 300) according to claim 1, wherein:

- the servo circuit (102) comprises a first multi-phase converter (108) between the first phase accumulator (106) and the phase comparison block (110), configured to implement the first multi-phase correspondence matrix; and
- the feedback loop (104) comprises a second multi-phase converter (124) between the second phase accumulator (122) and the phase comparison block (110), configured to implement the second multi-phase correspondence matrix.

3. The frequency synthesis device (100; 200; 300) according to claim 2, wherein each of the first and second multi-phase converters (108, 124) implements its multi-phase correspondence matrix in the form a set of logic gates (800 to 820) receiving as input a current value of phase accumulation binary coded on $\ln(T)/\ln(2)$ bits, where $\ln(.)$ is the natural logarithm function, and providing at output T current values of logic levels.

4. The frequency synthesis device (100; 200; 300) according to any one of claims 1 to 3, wherein each coefficient of each of the first and second multi-phase correspondence matrices is either at a first binary value indicative of a first logic level of logic signal, or at a second binary value indicative of a second logic level of logic signal.

5. The frequency synthesis device (100; 200; 300) according to claim 4, wherein each row or column of each of the first and second multi-phase correspondence matrices, when this row or column indicates the logic levels that must be taken by one of the T first or second logic signals for the T possible phase accumulation discrete values, circularly presents by modulo T only a single transition from the first binary value to the second binary value for a first half of the T possible phase accumulation discrete values and only a single transition from the second binary value to the first binary value for a second half of the T possible phase accumulation discrete values.

6. The frequency synthesis device (100; 200; 300) according to claim 4 or 5, wherein each row or column of each of the first and second multi-phase correspondence matrices, when this row or column indicates the logic levels that must be taken by one of the first T or second logic signals for the T possible phase accumulation discrete values, differs from that which precedes or from that which follows only by a shift of a column or respectively a line modulo T of the coefficient values it contains, this shift remaining in the same direction from the first to the last row or column.

7. The frequency synthesis device (100; 200; 300) according to any one of claims 1 to 6, wherein each of the first and second correspondence matrices is symmetrical.

8. The frequency synthesis device (100; 200; 300) according to any one of claim s 1 to 7, wherein the first and second correspondence matrices are identical.

9. The frequency synthesis device (100; 200; 300) according to any one of claims 1 to 8, wherein the phase comparison block (110) comprises T charge pumps (114) receiving respectively in continuous time T pairs of pulse signals supplied by the T phase comparators (112) and supplying T output currents in continuous time respectively.

10. The frequency synthesis device (100; 200; 300) according to claim 9, wherein the phase comparison block (110) comprises a current summator (116) receiving in parallel the T output currents supplied by the T charge pumps (114) for supplying a single summed current at the output of the phase comparison block (110).

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

[Fig. 13]

[Fig. 14]

[Fig. 15]

[Fig. 16]

[Fig. 17]

[Fig. 18]

[Fig. 19]

[Fig. 20]

## RÉFÉRENCES CITÉES DANS LA DESCRIPTION

**Documents brevets cités dans la description**

- FR 2763196 A1
- US 20110133795 A1
- WO 2009053531 A1
- US 2009085674 A1
- US 9509320 B2

**Littérature non-brevet citée dans la description**

- **STASZEWSKI et al.** Phase-domain all-digital phase-locked loop. *IEEE Transactions on Circuits and Systems-II: express briefs,* Mars 2005, vol. 52 (3), 159-163